# EUROPEAN PATENT APPLICATION

(11) **EP 4 387 417 A1**
(43) Date of publication of application: **19.06.2024**
(21) Application number: 23216305.5
(22) Date of filing: 13.12.2023
(51) Int. Cl.: H10K 50/844, H10K 50/858, H10K 59/80, H10K 59/122, H10K 59/12, H10K 71/20

(54) **DISPLAY PANEL AND MANUFACTURING METHOD OF THE SAME**

(30) Priority: 13.12.2022 KR 20220174099
(71) Applicant: Samsung Display Co., Ltd., Gyeonggi-Do (KR)
(72) Inventor: JO, Jungyun, Yongin-si (KR); BAE, Chulmin, Yongin-si (KR); SUNG, Woo Yong, Yongin-si (KR); LEE, Jeongseok, Yongin-si (KR)
(74) Representative: Marks & Clerk LLP

(57) **Abstract**

A display panel includes a base layer, a pixel defining layer defining a first emission opening and disposed on the base layer, a partition defining a first partition opening corresponding to the first emission opening and disposed on the pixel defining layer, a first light-emitting element including a first anode at least partially exposed by the first emission opening, a first cathode including at least a portion disposed within the first partition opening and contacting the partition, and a first emission pattern disposed between the first anode and the first cathode, a first lower encapsulation inorganic pattern partially overlapping the first emission opening and disposed on the first light-emitting element and the partition, and a first cover layer partially overlapping the first emission opening and disposed on the first lower encapsulation inorganic pattern.

## Description

### BACKGROUND

### 1. Field

The disclosure relates to a display panel and a method for manufacturing the same, and more particularly, to a display panel with improved process reliability and a method for manufacturing the same.

### 2. Description of the Related Art

A display device is activated according to an electrical signal. The display device may include a display panel displaying an image. Regarding the display panel, the organic light-emitting display panel has low power consumption, high luminance, and high response speed.

Among display panels, an organic light-emitting display panel includes an anode, a cathode, and an emission pattern. The emission pattern is separated for each emission area, and the cathode provides a common voltage to each emission area.

### SUMMARY

The disclosure provides a display panel including a light-emitting element formed without using a metal mask.

The inventive concept also provides a light-emitting element with improved process reliability and a display panel including the same.

An embodiment of the inventive concept provides a display panel including: a base layer; a pixel defining layer defining a first emission opening and disposed on the base layer; a partition defining a first partition opening corresponding to the first emission opening and disposed on the pixel defining layer; a first light-emitting element including a first anode at least partially exposed by the first emission opening, a first cathode including at least a portion disposed within the first partition opening and contacting the partition, and a first emission pattern disposed between the first anode and the first cathode; a first lower encapsulation inorganic pattern partially overlapping the first emission opening and disposed on the first light-emitting element and the partition; and a first cover layer partially overlapping the first emission opening and disposed on the first lower encapsulation inorganic pattern.

In an embodiment, the first cover layer may include a transparent conductive oxide.

In an embodiment, a refractive index of the first cover layer may be about 1.5 or more and about 2.0 or less.

In an embodiment, a difference between a refractive index of the first cover layer and a refractive index of the first lower encapsulation inorganic pattern may be 0.4 or less.

In an embodiment, the first cover layer may entirely overlap the first lower encapsulation inorganic pattern in a plan view.

In an embodiment, the first cover layer may contact an outer surface of the first lower encapsulation inorganic pattern and an upper surface of the partition.

In an embodiment, the first cover layer may include a first upper cover pattern spaced apart from the partition, and an outer surface of the first upper cover pattern may be substantially aligned with an outer surface of the first lower encapsulation inorganic pattern.

In an embodiment, the display panel may further include: a second light-emitting element including a second anode, a second emission pattern, and a second cathode; and a second lower encapsulation inorganic pattern, a second emission opening exposing at least a portion of the second anode may be defined in the pixel defining layer, a second partition opening corresponding to the second emission opening and having the second emission pattern and the second cathode disposed therein may be defined in the partition, and the second lower encapsulation inorganic pattern may partially overlap the second emission opening and may be disposed on the second light-emitting element and the partition.

In an embodiment, the first cover layer may include: a first portion covering the first and second lower encapsulation inorganic patterns and a nonoverlapping area with the first and second lower encapsulation inorganic patterns of an upper surface of the partition; and a second portion connected to the first portion, disposed between the partition and the second lower encapsulation inorganic pattern, and defining a first sub opening corresponding to the second emission opening.

In an embodiment, the second portion may have a closed-line shape in a plan view.

In an embodiment, a thickness of a portion of the first portion disposed on the first lower encapsulation inorganic pattern may be greater than a thickness of a portion of the first portion disposed on the second lower encapsulation inorganic pattern.

In an embodiment, the display panel may further include: a 1-1 dummy pattern contacting the partition, disposed on the partition, defining a first dummy opening corresponding to the first emission opening, and including the same material as that of the first emission pattern; and a 1-2 dummy pattern disposed on the second portion, defining a second dummy opening corresponding to the second emission opening, and including the same material as that of the second emission pattern.

In an embodiment, the display panel may further include; a third light-emitting element including a third anode, a third emission pattern, and a third cathode; a third lower encapsulation inorganic pattern; and a second cover layer disposed on the third lower encapsulation inorganic pattern, a third emission opening exposing at least a portion of the third anode may be defined in the pixel defining layer, a third partition opening corresponding to the third emission opening and having the third emission pattern and the third cathode disposed therein may be defined in the partition, the third lower encapsulation inorganic pattern may partially overlap the third emission opening and is disposed on the third light-emitting element and the partition, and the first cover layer may further include a third portion disposed between the partition and the third lower encapsulation inorganic pattern.

In an embodiment, the second cover layer may include a transparent conductive oxide.

In an embodiment, a thickness of the third portion may be greater than a thickness of the second portion.

In an embodiment, a thickness of the second cover layer may be less than a thickness of a portion of the first portion disposed on the first lower encapsulation inorganic pattern and a thickness of a portion of the first portion disposed on the second lower encapsulation inorganic pattern.

In an embodiment, the display panel may further include a second cover layer including a first lower cover pattern disposed between the partition and the second lower encapsulation inorganic pattern and defining a first sub opening corresponding to the second emission opening, the first cover layer includes: a first upper cover pattern partially overlapping the first emission opening and disposed on the first lower encapsulation inorganic pattern; and a second upper cover pattern partially overlapping the second emission opening and disposed on the second lower encapsulation inorganic pattern, and the second upper cover pattern may overlap the first lower cover pattern in a plan view.

In an embodiment, the first lower cover pattern may have a closed-line shape in a plan view.

In an embodiment, the second cover layer may include at least one of an inorganic film and a carbon film.

In an embodiment, a refractive index of the second cover layer may be about 1.5 or more and about 2.0 or less.

In an embodiment, the display panel may further include: a 1-1 dummy pattern contacting the partition, disposed on the partition, defining a first dummy opening corresponding to the first emission opening, and including the same material as that of the first emission pattern; and a 1-2 dummy pattern disposed on the first lower cover pattern, defining a second dummy opening corresponding to the second emission opening, and including the same material as that of the second emission pattern.

In an embodiment, the display panel may further include: a third light-emitting element including a third anode, a third emission pattern, and a third cathode; and a third lower encapsulation inorganic pattern, a third emission opening exposing at least a portion of the third anode may be defined in the pixel defining layer, a third partition opening corresponding to the third emission opening and having the third emission pattern and the third cathode disposed therein may be defined in the partition, the third lower encapsulation inorganic pattern may partially overlap the third emission opening and may be disposed on the third light-emitting element and the partition, the second cover layer may further include a second lower cover pattern disposed between the partition and the third lower encapsulation inorganic pattern and defining a second sub opening corresponding to the third emission opening, and the first cover layer may further include a third upper cover pattern partially overlapping the third emission opening, disposed on the third lower encapsulation inorganic pattern, and overlapping the second lower cover pattern in a plan view.

In an embodiment, the partition may include: a first layer including a first inner surface defining a first area of the first partition opening and having a first conductivity; and a second layer including a second inner surface defining a second area of the first partition opening, having a second conductivity and disposed on the first layer, the first conductivity may be higher than the second conductivity, and the first inner surface may be recessed inward than the second inner surface.

In an embodiment of the inventive concept, a display panel manufacturing method includes: providing a preliminary display panel including a base layer, a first anode disposed on the base layer, a pixel defining layer disposed on the base layer and defining a first emission opening exposing a portion of the first anode, and a partition disposed on the pixel defining layer and defining a first partition opening corresponding to the first emission opening; forming a first emission pattern within the first emission opening and the first partition opening; forming a first cathode on the first emission pattern; forming a first mask pattern on a portion of the first cathode and the partition adjacent to the first partition opening; etching using the first mask pattern; and forming a first protective layer on the first cathode and the partition. In the forming the first emission pattern, a 1-1 dummy layer including the same material as that of the first emission pattern and disposed on the partition is formed. In the etching using the first mask pattern, a 1-1 dummy pattern is formed from the 1-1 dummy layer. The first protective layer covers an outer surface of the 1-1 dummy pattern.

In an embodiment, in the forming the first protective layer, a conductive material may be deposited, and the first protective layer may be formed from the first mask pattern and the deposited conductive material.

In an embodiment, in the forming the first protective layer, at least one of an inorganic material and carbon may be deposited, and the first protective layer may cover the first mask pattern.

In an embodiment, after the forming the first protective layer, the method may further include: defining a first sub opening in the first protective layer; defining a second partition opening in the partition; defining a second emission opening in the pixel defining layer; forming a second emission pattern within the second emission opening and the second partition opening; forming a second cathode on the second emission pattern; forming a second mask pattern on the second cathode and a portion of the partition adjacent to the second partition opening; etching using the second mask pattern; and forming a second protective layer on the first and second cathodes and the partition. In the providing the preliminary display panel, the preliminary display panel may further include a second anode spaced apart from the first anode. The first sub opening may overlap the second anode.

In an embodiment, in the forming the second emission pattern, a 1-2 dummy layer including the same material as that of the second emission pattern and disposed on the partition may be formed. In the etching using the second mask pattern, a 1-2 dummy pattern may be formed from the 1-2 dummy layer. In the forming the second protective layer, a conductive material may be deposited, and the second protective layer may be formed from the second mask pattern and the deposited conductive material. The second protective layer may cover an outer surface of the 1-2 dummy pattern.

In an embodiment, in the etching using the second mask pattern, a portion of the first protective layer that does not overlap with the second mask pattern may be removed to form a first protective pattern.

In an embodiment, in the forming the second protective layer, at least one of an inorganic material and carbon may be deposited, the second protective layer may be formed from the first protective pattern and the deposited at least one of inorganic material and carbon, and the second protective layer may cover the first and second mask patterns.

At least some of the above and other features of the invention are set out in the claims.

### BRIEF DESCRIPTION OF THE DRAWINGS

The accompanying drawings are included to provide a further understanding of the inventive concept, and are incorporated in and constitute a part of this specification. The drawings illustrate embodiments of the inventive concept and, together with the description, serve to explain principles of the inventive concept. In the drawings:
FIG. 1A is a perspective view of an embodiment of a display device according to the inventive concept;
FIG. 1B is an exploded perspective view of an embodiment of a display device according to the inventive concept;
FIG. 2 is a cross-sectional view of an embodiment of a display panel according to the inventive concept;
FIG. 3 is a plan view of an embodiment of a display panel according to the inventive concept;
FIG. 4 is an enlarged plan view of an embodiment of a part of a display area of a display panel according to the inventive concept;
FIGS. 5A and 5B are cross-sectional views of an embodiment of a display panel in an embodiment taken along line I-I' of FIG. 4;
FIG. 6 is an enlarged plan view of an embodiment of some components of a display panel according to the inventive concept;
FIG. 7 is a cross-sectional view of an embodiment of a display panel in an embodiment taken along line I-I' of FIG. 4;
FIG. 8 is an enlarged plan view of an embodiment of some components of a display panel according to the inventive concept.
FIGS. 9A to 9J are cross-sectional views illustrating an embodiment of some of steps in a method of manufacturing a display panel according to the inventive concept;
FIGS. 10A to 10H are cross-sectional views illustrating an embodiment of some of steps in a method of manufacturing a display panel according to the inventive concept;

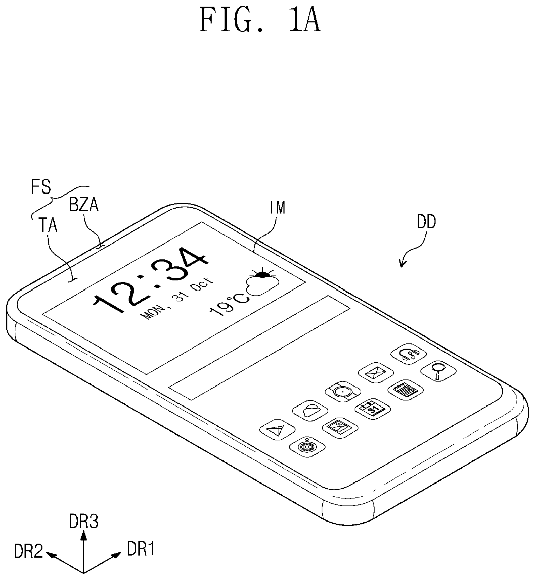

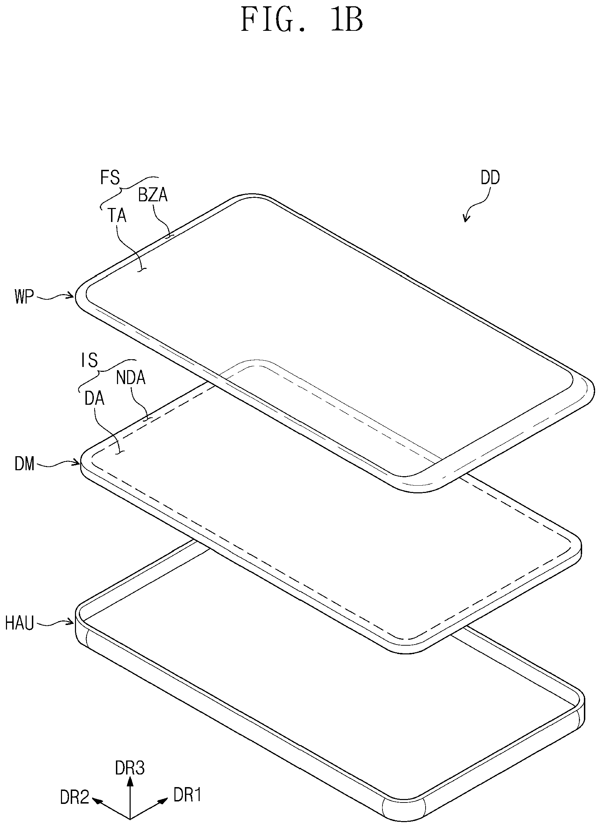

FIGS. 1 1A to 11G are cross-sectional views illustrating an embodiment of some of steps in a method of manufacturing a display panel according to the inventive concept; and

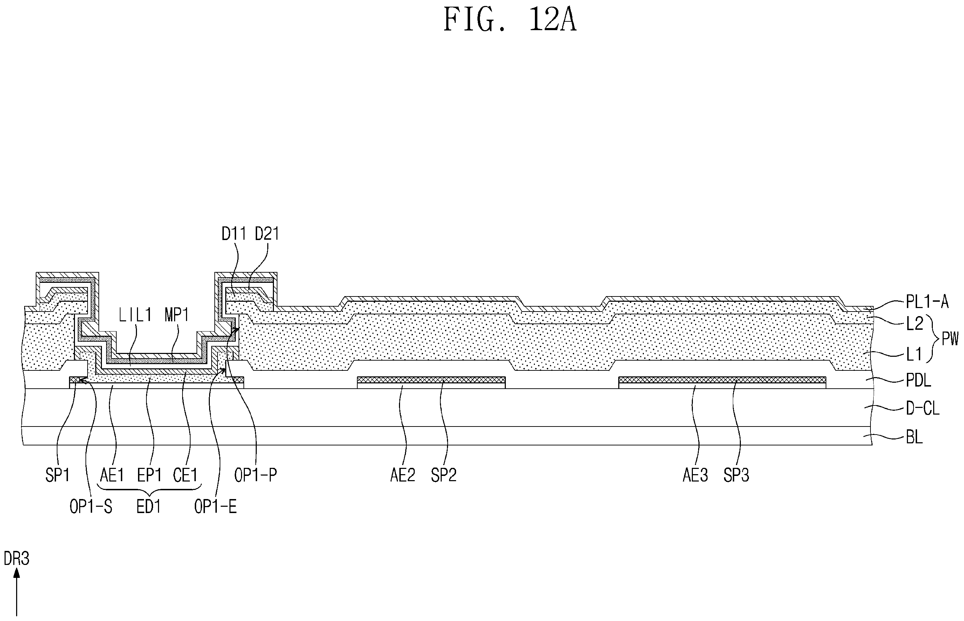

FIGS. 12A to 12E are cross-sectional views illustrating an embodiment of some of steps in a method of manufacturing a display panel according to the inventive concept.

### DETAILED DESCRIPTION

In this specification, when an element (or region, layer, part, etc.) is referred to as being "on", "connected to", or "coupled to" another element, it means that it may be directly placed on/connected to/coupled to other components, or a third component may be arranged between them.

Like reference numerals refer to like elements. Additionally, in the drawings, the thicknesses, proportions, and dimensions of components are exaggerated for effective description. "And/or" includes all of one or more combinations defined by related components.

It will be understood that the terms "first" and "second" are used herein to describe various components but these components should not be limited by these terms. The above terms are used only to distinguish one component from another. For example, a first component may be referred to as a second component and vice versa without departing from the scope of the inventive concept. The terms of a singular form may include plural forms unless otherwise specified.

In addition, terms such as "below", "the lower side", "on", and "the upper side" are used to describe a relationship of components shown in the drawing. The terms are described as a relative concept based on a direction shown in the drawing.

In various embodiments of the inventive concept, the terms "include," "comprise," "including," or "comprising," specify a property, a region, a fixed number, a step, a process, an element and/or a component but do not exclude other properties, regions, fixed numbers, steps, processes, elements and/or components.

"About" or "approximately" as used herein are inclusive of the stated value and mean within an acceptable range of deviation for the particular value as determined by one of ordinary skill in the art, considering the measurement in question and the error associated with measurement of the particular quantity (i.e., the limitations of the measurement system). The term "about" can mean within one or more standard deviations, or within ± 30%, 20%, 10%, 5% of the stated value, for example.

Unless otherwise defined, all terms (including technical and scientific terms) used herein have the same meaning as commonly understood by one of ordinary skill in the art to which this inventive concept belongs. In addition, terms such as terms defined in commonly used dictionaries should be interpreted as having a meaning consistent with the meaning in the context of the related technology, and it should not be construed in an overly ideal or overly formal sense unless explicitly defined here.

Hereinafter, embodiments of the inventive concept will be described with reference to the drawings.

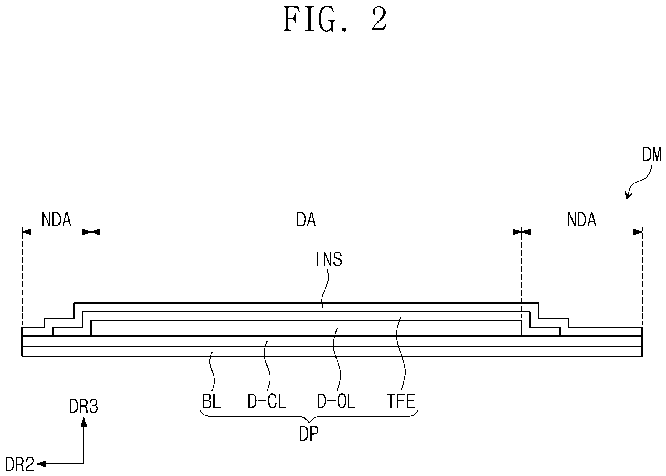

FIG. 1A is a perspective view of an embodiment of a display device according to the inventive concept. FIG. 1B is an exploded perspective view of an embodiment of a display device. FIG. 2 is a cross-sectional view of an embodiment of a display panel according to the inventive concept.

In an embodiment, the display device DD may be a relatively large electronic device, such as a television, a monitor, or an external billboard. In addition, the display device DD may be a relatively small and medium-sized electronic device, such as a personal computer, a notebook computer, a personal digital terminal, a car navigation system, a game machine, a smart phone, a tablet, or a camera. These are presented only as illustrative embodiments, and other display devices may be employed without departing from the concept of the inventive concept. In this embodiment, the display device DD is shown in an embodiment of a smart phone.

Referring to FIGS. 1A, 1B, and 2, the display device DD may display an image IM in a third direction DR3 on a display surface FS parallel to first and second directions DR1 and DR2, respectively. The image IM may include a still image as well as a dynamic image. In FIG. 1A, a watch window and icons are illustrated in an embodiment of the image IM. The display surface FS on which the image IM is displayed may correspond to a front surface of the display device DD.

In this embodiment, the front (or upper surface) and the rear surface (or lower surface) of each member are defined based on the direction in which the image IM is displayed. The front and rear surfaces are opposing to each other in the third direction DR3, and a normal direction of each of the front and rear surfaces may be parallel to the third direction DR3. Moreover, the directions indicated by the first to third directions DR1, DR2, and DR3 are relative concepts and may be converted to other directions. In this specification, "a plan view" may mean a view in the third direction DR3.

As shown in FIG. 1B, the display device DD in the illustrated embodiment may include a window WP, a display module DM, and a housing HAU. The window WP and the housing HAU may be coupled to each other to configure the exterior of the display device DD.

The window WP may include an optically transparent insulating material. In an embodiment, the window WP may include glass or plastic. The front surface of the window WP may define the display surface FS of the display device DD, for example. The display surface FS may include a transmissive area TA and a bezel area BZA. The transmissive area TA may be an optically transparent area. In an embodiment, the transmissive area TA may be an area having a visible light transmittance of about 90% or more, for example.

The bezel area BZA may be an area having relatively low light transmittance compared to the transmissive area TA. The bezel area BZA may define the shape of the transmissive area TA. The bezel area BZA is adjacent to the transmissive area TA and may surround the transmissive area TA. This is shown as an illustrative embodiment, and in the window WP in another embodiment of the inventive concept, the bezel area BZA may be omitted. The window WP may include at least one functional layer of an anti-fingerprint layer, a hard coating layer, and an anti-reflection layer, and is not limited to any particular embodiment.

The display module DM may be disposed below the window WP. The display module DM may be a component that substantially generates the image IM. The image IM generated by the display module DM is displayed on the display surface IS of the display module DM and is recognized by the user from the outside through the transmissive area TA.

The display module DM includes a display area DA and a non-display area NDA. The display area DA may be an area activated according to an electrical signal. The non-display area NDA is adj acent to the display area DA. The non-display area NDA may surround the display area DA. The non-display area NDA is an area covered by the bezel area BZA and may not be visible from the outside.

As shown in FIG. 2, the display module DM in the illustrated embodiment may include a display panel DP and an input sensor INS. Although not separately shown, the display device DD in an embodiment of the inventive concept may further include a protection member disposed on a lower surface of the display panel DP or an anti-reflection member and/or a window member disposed on an upper surface of the input sensor INS.

The display panel DP may be a light-emitting display panel, and is not particularly limited. In an embodiment, the display panel DP may be an organic light-emitting display panel or an inorganic light-emitting display panel, for example. The light-emitting layer in the organic light-emitting display panel includes an organic light-emitting material. A light-emitting layer in the inorganic light-emitting display panel includes quantum dots, quantum rods, or micro light-emitting diodes ("LEDs"). Hereinafter, the display panel DP is described as the organic light-emitting display panel.

The display panel DP may include a base layer BL, and a circuit element layer D-CL, a display element layer D-OL, and an encapsulation layer TFE disposed on the base layer BL. The input sensor INS may be directly disposed on the encapsulation layer TFE. In this specification, "component A is directly disposed on component B" means that an adhesive layer is not disposed between component A and component B.

The base layer BL may include at least one plastic film. The base layer BL is a flexible substrate and may include a plastic substrate, a glass substrate, a metal substrate, or an organic/inorganic composite material substrate. In this specification, it may be seen that the display area DA and the non-display area NDA are defined in the base layer BL, and in this case, components disposed on the base layer BL may be viewed as overlapping with the display area DA or the non-display area NDA.

The circuit element layer D-CL includes at least one insulating layer and circuit elements. The insulating layer includes at least one inorganic layer and at least one organic layer. The circuit element includes signal lines, a driving circuit of a pixel, or the like.

The display element layer D-OL includes a partition and a light-emitting element. The light-emitting element includes an anode, an emission pattern, and a cathode, and the emission pattern may include at least a light-emitting layer.

The encapsulation layer TFE includes a plurality of thin films. Some thin films improve optical efficiency, and some thin films protect organic light-emitting diodes.

The input sensor INS acquires coordinate information of an external input. The input sensor INS may have a multilayer structure. The input sensor INS may include a single layer or multiple conductive layers. The input sensor INS may include a single or multilayer insulating layer. The input sensor INS may sense an external input in a capacitive manner, for example. In the inventive concept, the operation method of the input sensor INS is not particularly limited, and in an embodiment of the inventive concept, the input sensor INS may sense an external input using an electromagnetic induction method or a pressure sensing method. In another embodiment of the inventive concept, the input sensor INS may be omitted.

As shown in FIG. 1B, the housing HAU may be coupled to the window WP. The housing HAU may be coupled to the window WP to provide a predetermined inner space. The display module DM may be accommodated in the inner space.

The housing HAU may include a material with relatively high rigidity. In an embodiment, the housing HAU may include a plurality of frames and/or plates including glass, plastic, or metal, or any combinations thereof, for example. The housing HAU may stably protect components of the display device DD accommodated in the internal space from external impact.

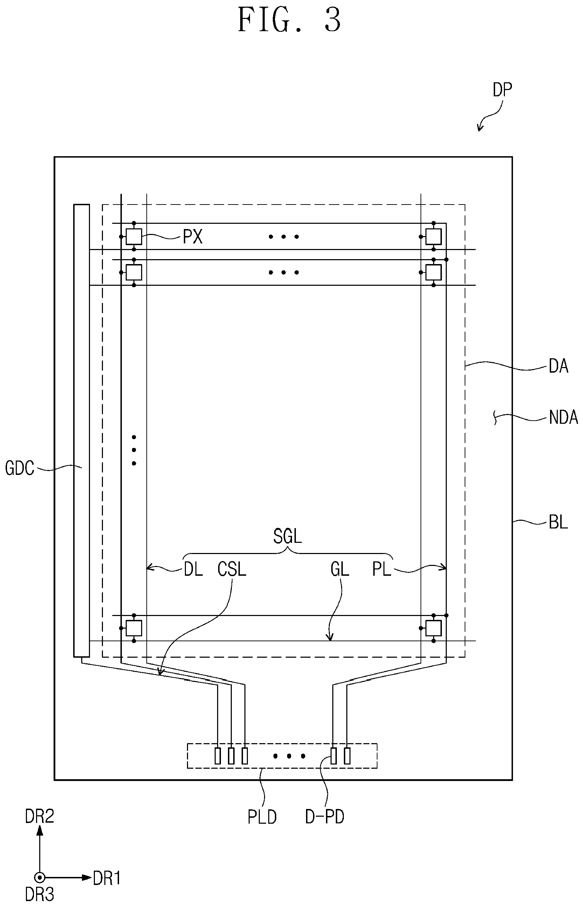

FIG. 3 is a plan view of an embodiment of a display panel according to the inventive concept.

Referring to FIG. 3, the display panel DP may include a base layer BL divided into the display area DA and the non-display area NDA described with reference to FIG. 2.

The display panel DP may include pixels PX disposed in the display area DA and signal lines SGL electrically connected to the pixels PX. The display panel DP may include a driving circuit GDC and a pad part PLD disposed in the non-display area NDA.

The pixels PX may be arranged in the first and second directions DR1 and DR2. The pixels PX may include a plurality of pixel rows extending in the first direction DR1 and arranged in the second direction DR2, and a plurality of pixel columns extending in the second direction DR2 and aligned in the first direction DR1.

The signal lines SGL may include gate lines GL, data lines DL, a power line PL, and a control signal line CSL. Each of the gate lines GL may be connected to a corresponding pixel of the pixels PX, and each of the data lines DL may be connected to a corresponding pixel of the pixels PX. The power line PL may be electrically connected to the pixels PX. The control signal line CSL may be connected to the driving circuit GDC to provide control signals to the driving circuit GDC.

The driving circuit GDC may include a gate driving circuit. The gate driving circuit may generate gate signals and sequentially output the generated gate signals to the gate lines GL. The gate driving circuit may further output another control signal to the pixel driving circuit.

The pad part PLD may be a part to which the flexible circuit board is connected. The pad part PLD may include pixel pads D-PD, and the pixel pads D-PD may be pads for connecting the flexible circuit board to the display panel DP. Each of the pixel pads D-PD may be connected to a corresponding signal line among the signal lines SGL. The pixel pads D-PD may be connected to corresponding pixels PX through signal lines SGL. Also, one of the pixel pads D-PD may be connected to the driving circuit GDC.

Also, the pad part PLD may further include input pads. The input pads may be pads for connecting the flexible circuit board to the input sensor INS (refer to FIG. 2). However, the inventive concept is not limited thereto, and the input pads may be disposed on the input sensor INS (refer to FIG. 2) and connected to the pixel pads D-PD and a separate circuit board. In an alternative embodiment, the input sensor INS (refer to FIG. 2) may be omitted and input pads may not be further included.

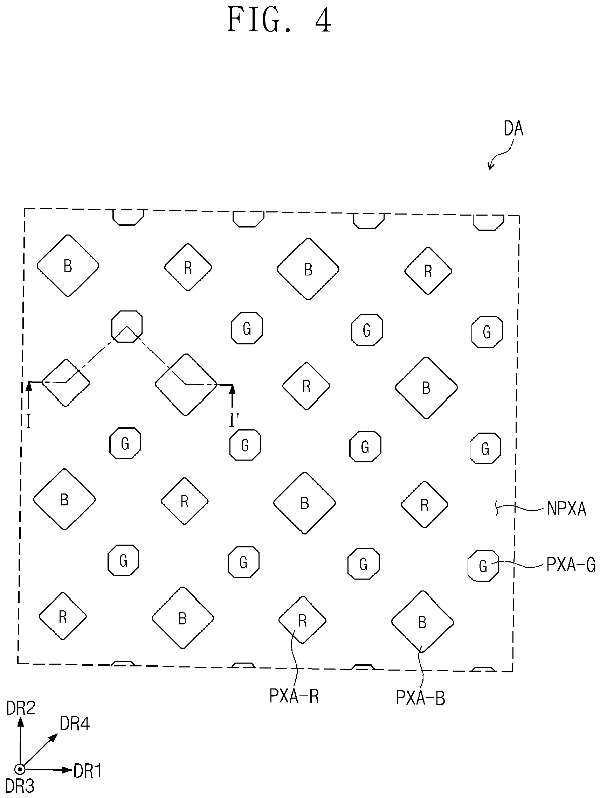

FIG. 4 is an enlarged plan view of a part of a display area of a display panel according to the inventive concept. FIG. 4 is a plan view of the display module DM (refer to FIG. 2) viewed from the display surface IS (refer to FIG. 1B) of the display module DM (refer to FIG. 2) and shows the arrangement of emission areas PXA-R, PXA-G, and PXA-B.

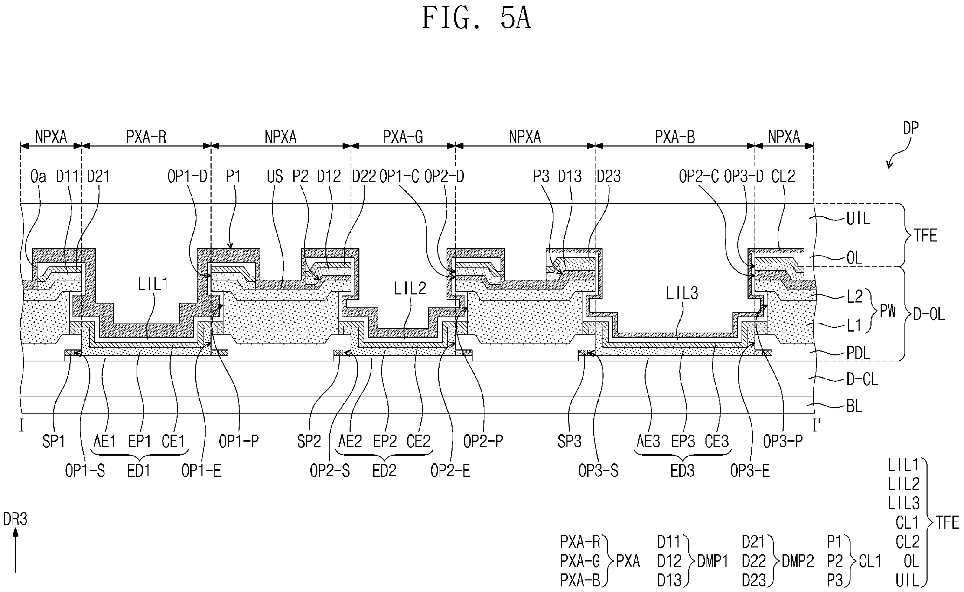

Referring to FIG. 4, the display area DA may include first to third emission areas PXA-R, PXA-G, and PXA-B and a peripheral area NPXA surrounding the first to third emission areas PXA-R, PXA-G, and PXA-B. The first to third emission areas PXA-R, PXA-G, and PXA-B may respectively correspond to areas in which light provided from the light-emitting elements ED1, ED2, and ED3 (refer to FIG. 5A) is emitted. The first to third emission areas PXA-R, PXA-G, and PXA-B may be classified according to the color of light emitted toward the outside of the display module DM (refer to FIG. 2).

The first to third emission areas PXA-R, PXA-G, and PXA-B may provide first to third color lights having different colors, respectively. In an embodiment, the first color light may be red light, the second color light may be green light, and the third color light may be blue light, for example. However, embodiments of the first to third color lights are not necessarily limited to the above example.

Each of the first to third emission areas PXA-R, PXA-G, and PXA-B may be defined as an area in which an upper surface of the anode is exposed by an emission opening to be described later. The peripheral area NPXA may set boundaries of the first to third emission areas PXA-R, PXA-G, and PXA-B, and may prevent color mixing between the first to third emission areas PXA-R, PXA-G, and PXA-B.

Each of the first to third emission areas PXA-R, PXA-G, and PXA-B may be provided in plural to have a predetermined arrangement within the display area DA and may be repeatedly arranged. In an embodiment, the first and third emission areas PXA-R and PXA-B may be alternately arranged along the first direction DR1 to form a 'first group', for example. The second emission areas PXA-G may be arranged along the first direction DR1 to form a 'second group'. Each of the 'first group' and the 'second group' may be provided in plural numbers, and the 'first groups' and 'second groups' may be alternately arranged along the second direction DR2.

One second emission area PXA-G may be spaced apart from one first emission area PXA-R or one third emission area PXA-B in the fourth direction DR4. The fourth direction DR4 may be defined as a direction between the first and second directions DR1 and DR2.

FIG. 4 illustrates an arrangement form of the first to third emission areas PXA-R, PXA-G, and PXA-B, but the inventive concept is not limited thereto and the first to third emission areas PXA-R, PXA-G, and PXA-B may be arranged in various forms. In an embodiment, the first to third emission areas PXA-R, PXA-G, and PXA-B may have a PENTILE^{™} arrangement as shown in FIG. 4. In an alternative embodiment, the first to third emission areas PXA-R, PXA-G, and PXA-B may have a stripe arrangement or a diamond pixel^{™} arrangement.

The first to third emission areas PXA-R, PXA-G, and PXA-B may have various shapes in a plan view. In an embodiment, the first to third emission areas PXA-R, PXA-G, and PXA-B may have polygonal, circular, or elliptical shapes. FIG. 4 shows first and third emission areas PXA-R and PXA-B having a quadrangular shape (or rhombic shape) and a second emission area PXA-G having an octagonal shape in a plan view, for example.

The first to third emission areas PXA-R, PXA-G, and PXA-B may have the same shape in a plan view, or at least some of them may have different shapes. FIG. 4 shows first and third emission areas PXA-R and PXA-B having the same shape in a plan view and a second emission area PXA-G having a shape different from that of the first and third emission areas PXA-R and PXA-B.

At least some of the first to third emission areas PXA-R, PXA-G, and PXA-B may have different areas in a plan view. In an embodiment, the area of the first emission area PXA-R emitting red light may be larger than the area of the second emission area PXA-G emitting green light, and may be smaller than the area of the third emission area PXA-B emitting blue light. However, the size relationship of the area between the first to third emission areas PXA-R, PXA-G, and PXA-B according to the emission color is not limited thereto, and may vary according to the design of the display module DM (refer to FIG. 2). In addition, the inventive concept is not limited thereto, and the first to third emission areas PXA-R, PXA-G, and PXA-B may have the same area in a plan view.

The shape, area, and arrangement of the first to third emission areas PXA-R, PXA-G, and PXA-B of the display module DM (refer to FIG. 2) of the inventive concept may be designed in various ways depending on the color of the emitted light or the size and configuration of the display module DM (refer to FIG. 2), and are not limited to the embodiment shown in FIG. 4.

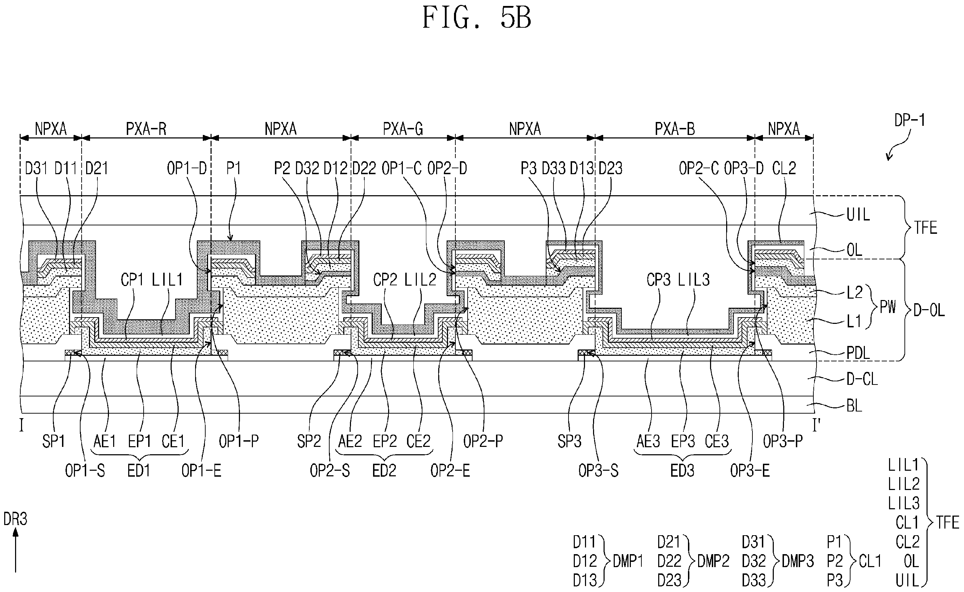

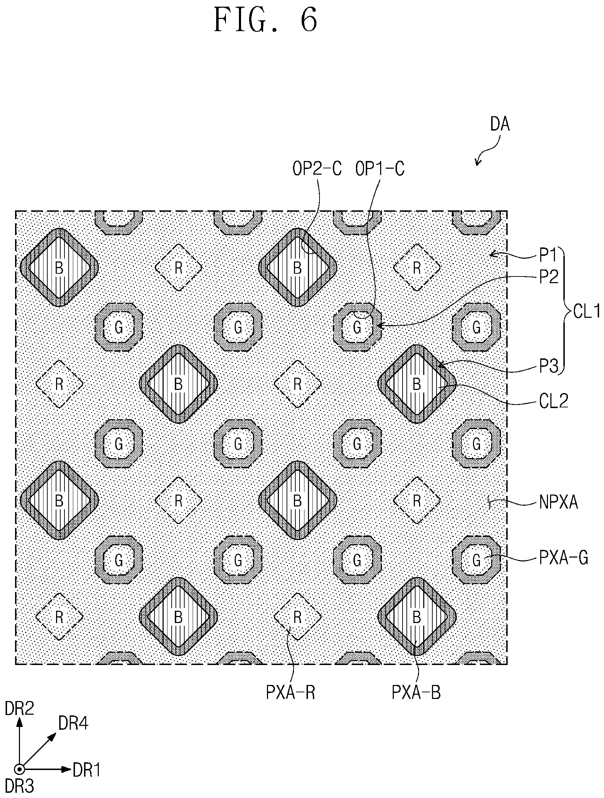

FIGS. 5A and 5B are cross-sectional views of a display panel in an embodiment taken along line I-I' of FIG. 4. FIG. 6 is an enlarged plan view of some components of a display panel according to the inventive concept.

Referring to FIGS. 5A, 5B, and 6, the display panels DP and DP-1 in the illustrated embodiment may include a base layer BL, a circuit element layer D-CL, a display element layer D-OL, and an encapsulation layer TFE.

The display panels DP and DP-1 may include a plurality of insulating layers, a semiconductor pattern, a conductive pattern, a signal line, or the like. An insulating layer, a semiconductor layer, and a conductive layer are formed by a method such as coating or vapor deposition. Thereafter, the insulating layer, the semiconductor layer, and the conductive layer may be selectively patterned by photolithography and etching. In this way, semiconductor patterns, conductive patterns, signal lines, or the like included in the circuit element layer D-CL and the display element layer D-OL are formed.

The circuit element layer D-CL is shown as a single layer, but this is simply shown for easy explanation, and the circuit element layer D-CL may include an insulating layer, a semiconductor pattern, a conductive pattern, or the like for forming various elements.

The driving circuit of the pixel in the circuit element layer D-CL is provided in plural to be connected to the light-emitting elements ED1, ED2, and ED3, respectively, and to independently control the light-emitting elements ED1, ED2, and ED3. Each of the driving circuits of the pixel may include a plurality of transistors for driving a connected light-emitting element, at least one capacitor, and signal lines connecting them.

A display element layer D-OL may be disposed on the circuit element layer D-CL. According to this embodiment, the display element layer D-OL may include light-emitting elements ED1, ED2, and ED3, a pixel defining layer PDL, a partition PW (or conductive partition), and dummy patterns DMP1 and DMP2.

The light-emitting elements ED1, ED2, and ED3 include a first light-emitting element ED1, a second light-emitting element ED2, and a third light-emitting element ED3, and each of the first to third light-emitting elements ED1, ED2, and ED3 includes an anode (or first electrode), a cathode (or second electrode), and an emission pattern disposed between the anode and the cathode. The first light-emitting element ED1 includes a first anode AE1, a first cathode CE1, and a first emission pattern EP1, and the second light-emitting element ED2 includes a second anode AE2, a second cathode CE2, and a second emission pattern EP2, and the third light-emitting element ED3 includes the third anode AE3, a third cathode CE3, and a third emission pattern EP3.

The first to third anodes AE1, AE2, and AE3 (or the 1-1, 1-2, and 1-3 electrodes) may be provided in plural of patterns. The first to third anodes AE1, AE2, and AE3 may have conductivity. In an embodiment, each of the first to third anodes AE1, AE2, and AE3 may include or consist of various materials as long as they have conductivity, such as metal, transparent conductive oxide ("TCO"), or a conductive polymer material, for example. In an embodiment, the metal may include gold (Au), silver (Ag), aluminium (Al), magnesium (Mg), lithium (Li), molybdenum (Mo), copper (Cu), or any alloys thereof, for example. Transparent conductive oxides may include Indium Tin Oxide ("ITO"), Indium Zinc Oxide ("IZO"), Zinc Oxide (ZnO), Indium Oxide (InO), Indium Gallium Oxide ("IGO"), or Aluminium Zinc Oxide ("AZO").

Each of the first to third anodes AE1, AE2, and AE3 is shown as a single layer, but this is shown in an embodiment, and each of the first to third anodes AE1, AE2, and AE3 may have a multilayer structure, and any one of the first to third anodes AE1, AE2, and AE3 may have a single-layer structure and the other may have a multilayer structure, and is not limited to any particular embodiment.

The first to third emission patterns EP1, EP2, and EP3 may be disposed on the first to third anodes AE1, AE2, and AE3, respectively. The first to third emission patterns EP1, EP2, and EP3 may be patterned by a tip portion defined in a partition PW to be described later.

In an embodiment, the first emission pattern EP1 may provide red light, the second emission pattern EP2 may provide green light, and the third emission pattern EP3 may provide blue light.

Each of the first to third emission patterns EP1, EP2, and EP3 may include a light-emitting layer including a light-emitting material. Each of the first to third emission patterns EP1, EP2, and EP3 may further include a hole injection layer ("HIL") and a hole transport layer ("HTL") disposed between a corresponding anode of the first to third anodes AE1, AE2, and AE3 and a light-emitting layer, and may further include an electron transport layer ("ETL") and an electron injection layer ("EIL") disposed on the light-emitting layer. The first to third emission patterns EP1, EP2, and EP3 may be also referred to as 'first to third organic layers' or 'first to third intermediate layers', respectively.

The first to third cathodes CE1, CE2, and CE3 (or the 2-1, 2-2, and 2-3 electrodes) may be disposed on a corresponding emission pattern among the first to third emission patterns EP1, EP2, and EP3. The first to third cathodes CE1, CE2, and CE3 may be patterned by a tip portion defined in a partition PW to be described later.

A pixel defining layer PDL may be disposed on an insulating layer disposed on an uppermost side of a circuit element layer D-CL. First to third emission openings OP1-E, OP2-E, and OP3-E may be defined in the pixel defining layer PDL. The first to third emission openings OP1-E, OP2-E, and OP3-E may correspond to the first to third anodes AE1, AE2, and AE3, respectively. The pixel defining layer PDL may expose at least a portion of each of the first to third anodes AE1, AE2, and AE3 through the first to third emission openings OP1-E, OP2-E, and OP3-E.

The first emission area PXA-R is defined as an area exposed by the first emission opening OP1-E on the upper surface of the first anode AE1, the second emission area PXA-G is defined as an area exposed by the second emission opening OP2-E on the upper surface of the second anode AE2, and the third emission area PXA-B is defined as an area exposed by the third emission opening OP3-E on the upper surface of the third anode AE3.

The pixel defining layer PDL may be an inorganic insulating film. In an embodiment, the pixel defining layer PDL may include silicon oxide, silicon nitride, or any combinations thereof, for example. In an embodiment, a pixel defining layer PDL may have a two-layer structure in which a silicon oxide layer and a silicon nitride layer are sequentially stacked, for example. However, this is an illustrative embodiment and when the pixel defining layer PDL may be an inorganic insulating film, a material, a single layer, or a multilayer may be variously used, and this is not limited to any particular embodiment.

In an embodiment of the inventive concept, the display panel DP may further include first to third sacrificial patterns SP1, SP2, and SP3. The first to third sacrificial patterns SP1, SP2, and SP3 may be disposed on upper surfaces of the first to third anodes AE1, AE2, and AE3, respectively. The first to third sacrificial patterns SP1, SP2, and SP3 may be covered by the pixel defining layer PDL. Each of the first to third sacrificial patterns SP1, SP2, and SP3 exposes at least a portion of the corresponding one of the first to third anodes AE1, AE2, and AE3. The first to third sacrificial patterns SP1, SP2, and SP3 may be disposed at positions that do not overlap with the first to third emission openings OP1-E, OP2-E, and OP3-E, respectively.

When the display panel DP further includes the first to third sacrificial patterns SP1, SP2, and SP3, upper surfaces of the first to third anodes AE1, AE2, and AE3 may be spaced apart from the pixel defining layer PDL in cross section with corresponding sacrificial patterns among the first to third sacrificial patterns SP1, SP2, and SP3 therebetween. Accordingly, it is possible to protect the first to third anodes AE1, AE2, and AE3 from being damaged in the process of forming the first to third emission openings OP1-E, OP2-E, and OP3-E.

In an embodiment, sacrificial openings OP1-S, OP2-S, and OP3-S respectively corresponding to the first to third emission openings OP1-E, OP2-E, and OP3-E may be defined in the first to third sacrificial patterns SP1, SP2, and SP3. Each of the sacrificial openings OP1-S, OP2-S, and OP3-S may have a larger area than corresponding one of the first to third emission openings OP1-E, OP2-E, and OP3-E. However, the inventive concept is not limited thereto, and the inner surfaces of the first to third sacrificial patterns SP1, SP2, and SP3 defining the sacrificial openings OP1-S, OP2-S, and OP3-S may be substantially aligned with the inner surface of the pixel defining layer PDL defining the corresponding first to third emission openings OP1-E, OP2-E, and OP3-E. At this time, each of the first to third emission areas PXA-R, PXA-G, and PXA-B may be seen as an area of the first to third anodes AE1, AE2, and AE3 exposed from the corresponding sacrificial openings OP1-S, OP2-S, and OP3-S.

The partition PW is placed on the pixel defining layer PDL. First to third partition openings OP1-P, OP2-P, and OP3-P may be defined in the partition PW. The first to third partition openings OP1-P, OP2-P, and OP3-P may correspond to the first to third emission openings OP1-E, OP2-E, and OP3-E, respectively. Each of the first to third partition openings OP1-P, OP2-P, and OP3-P may define an integral opening space with a corresponding emission opening. The first to third partition openings OP1-P, OP2-P, and OP3-P and the first to third emission openings OP1-E, OP2-E, and OP3-E integral with each other may expose at least a portion of the corresponding anodes AE1, AE2, and AE3.

The partition PW may have an undercut shape in cross section. The partition PW may include a plurality of layers sequentially stacked, and at least one of the plurality of layers may be recessed compared to adjacent stacked layers. Accordingly, the partition PW may include a tip portion.

The first to third emission patterns EP1, EP2, and EP3 and the first to third cathodes CE1, CE2, and CE3 are separated by the tip portion of the partition PW to be formed respectively in the first to third emission openings OP1-E, OP2-E, and OP3-E and the first to third partition openings OP1-P, OP2-P, and OP3-P.

According to this embodiment, the partition PW may include a first layer L1 and a second layer L2 disposed on the first layer L1. The first layer L1 may be disposed on a pixel defining layer PDL. The first layer L1 may be relatively depressed compared to the second layer L2 with respect to the emission areas PXA. That is, the first layer L1 may be formed by undercutting the second layer L2.

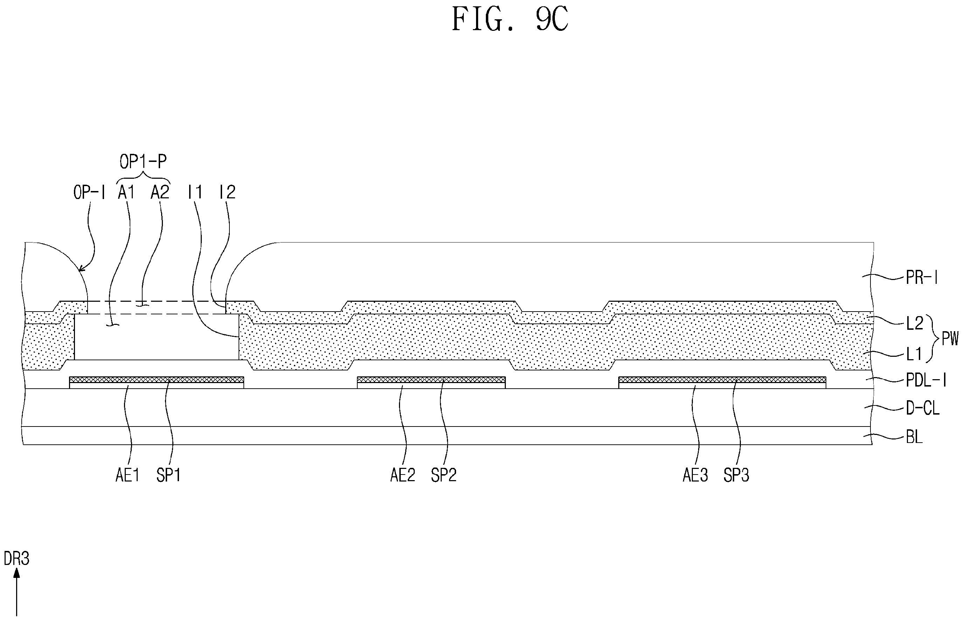

In this embodiment, each of the first to third partition openings OP1-P, OP2-P, and OP3-P defined in the partition PW may include a first area A1 (refer to FIG. 9C) and a second area A2 (refer to FIG. 9C). The first layer L1 may include inner surfaces defining a first area A1 (refer to FIG. 9C) of each of the first to third partition openings OP1-P, OP2-P, and OP3-P, and the second layer L2 may include inner surfaces defining a second area A2 (refer to FIG. 9C) of each of the first to third partition openings OP1-P, OP2-P, and OP3-P.

Each of the inner surfaces of the first layer L1 may be recessed inward relative to the inner surface of the second layer L2 with respect to corresponding emission areas PXA-R, PXA-G, and PXA-B. That is, the inner surface of the first layer L1 may be formed by undercutting the inner surface of the second layer L2. A portion of the second layer L2 protruding from the first layer L1 toward each of the first to third emission areas PXA-R, PXA-G, and PXA-B may define a tip portion.

In an embodiment, the first layer L1 may include a conductive material. The conductive material may include a metal, a transparent conductive oxide ("TCO"), or any combinations thereof. In an embodiment, the metal may include gold (Au), silver (Ag), aluminium (Al), magnesium (Mg), lithium (Li), molybdenum (Mo), titanium (Ti), copper (Cu), or any alloys thereof. Transparent conductive oxides may include Indium Tin Oxide ("ITO"), Indium Zinc Oxide ("IZO"), Zinc Oxide, Indium Oxide, Indium Gallium Oxide, Indium Gallium Zinc Oxide ("IGZO"), or Aluminium Zinc Oxide, for example.

In an embodiment, the second layer L2 may include a metal or non-metal. In an embodiment, the metal may include gold (Au), silver (Ag), aluminium (Al), magnesium (Mg), lithium (Li), molybdenum (Mo), titanium (Ti), copper (Cu), or any alloys thereof. The non-metal may include silicon (Si), silicon oxide (SiOx), silicon nitride (SiNx), silicon oxynitride (SiON), a metal oxide, a metal nitride, or any combinations thereof, and the metal oxide may include a transparent conductive oxide ("TCO"), for example.

In an embodiment, the partition PW may further include layers disposed below the first layer L1, above the second layer L2, or between the first layer L1 and the second layer L2. In this case, the additionally disposed layers may include at least one of the conductive material and the inorganic material.

The partition PW may receive a bias voltage. As the first to third cathodes CE1, CE2, and CE3 directly contact the partition PW, they may be electrically connected to each other and receive a bias voltage.

In this embodiment, the first layer L1 may have a relatively greater thickness than that of the second layer L2. The first layer L1 may directly contact the first to third cathodes CE1, CE2, and CE3. The first to third cathodes CE1, CE2, and CE3 may be physically separated by the second layer L2 forming the tip portion to be formed in each of the first to third emission openings OP1-E, OP2-E, and OP3-E and each of the first to third partition openings OP1-P, OP2-P, and OP3-P, and may be electrically connected to each other and receive a common voltage by contacting the first layer L1. The first layer L1 has a relatively high electrical conductivity and a relatively large thickness compared to the second layer L2, so that contact resistance with the first to third cathodes CE1, CE2, and CE3 may be reduced. Accordingly, a common cathode voltage may be uniformly provided to the first to third emission areas PXA-R, PXA-G, and PXA-B.

According to the inventive concept, the plurality of first emission patterns EP1 may be patterned and deposited in pixel units by tip portions defined in the partition PW. That is, the first emission patterns EP1 are commonly formed using an open mask, but may be easily divided into pixel units by a partition PW.

When the first emission patterns are patterned using a fine metal mask ("FMM"), a support spacer protruding from the partition must be provided to support the FMM. In addition, since the FMM is spaced apart from the base surface on which patterning is performed by the height of the partition and the spacer, there may be limitations in realizing relatively high resolution. In addition, as the FMM contacts the spacer, foreign matter may remain on the spacer after the patterning process of the first emission patterns EP1 or the spacer may be damaged by being etched by the FMM. Accordingly, a defective display panel may be formed. The description thereabout may be identically applied to the case of making the second emission patterns EP2 subject to patterning and the case of making the third emission patterns EP3 subject to patterning.

According to this embodiment, by including the partition PW, physical separation between the light-emitting elements ED1, ED2, and ED3 may be easily achieved. Accordingly, current leakage or driving error between adjacent emission areas PXA-R, PXA-G, and PXA-B is prevented, and independent driving is possible for each of the light-emitting elements ED1, ED2, and ED3.

In particular, by patterning the plurality of first emission patterns EP1 without a mask in contact with the internal structure in the display area DA (refer to FIG. 2), the display panel DP having improved process reliability by reducing the defect rate may be provided. The description thereabout may be identically applied to the case of making the second emission patterns EP2 subject to patterning and the case of making the third emission patterns EP3 subject to patterning. As patterning is possible even when a separate support spacer protruding from the partition PW is not provided, since the area of the first to third emission areas PXA-R, PXA-G, and PXA-B may be miniaturized, a display panel DP that may easily implement a relatively high resolution may be provided.

In addition, in manufacturing a relatively large area display panel DP, process costs may be reduced by omitting large-area mask production, and the display panel DP with improved process reliability may be provided as it is not affected by defects occurring in the large-area mask.

FIGS. 5A and 5B illustrate that the first to third emission patterns EP1, EP2, and EP3 do not contact inner surfaces of the first layer L1, but the inventive concept is not limited thereto, and the first to third emission patterns EP1, EP2, and EP3 may also contact inner surfaces of the first layer L1, respectively.

The dummy patterns DMP1 and DMP2 may be disposed on the partition PW. The dummy patterns DMP1 and DMP2 may include first dummy patterns DMP1 and second dummy patterns DMP2.

The first dummy patterns DMP1 may be disposed on the upper surface of the second layer L2. The first dummy patterns DMP1 may include a 1-1 dummy pattern D11, a 1-2 dummy pattern D12, and a 1-3 dummy pattern D13. The 1-1 to 1-3 dummy openings OP1-D, OP2-D, and OP3-D may be defined in the 1-1 to 1-3 dummy patterns D11, D12, and D13, respectively. The 1-1 to 1-3 dummy openings OP1-D, OP2-D, and OP3-D may correspond to the first to third emission areas PXA-R, PXA-G, and PXA-B, respectively. The 1-1 to 1-3 dummy patterns D11, D12, and D13 may have closed-line shapes enclosing the first to third emission areas PXA-R, PXA-G, and PXA-B, respectively, in the plan view.

The first dummy patterns DMP1 may include an organic material. The 1-1 to 1-3 dummy patterns D11, D12, and D13 may include the same material as that of the first to third emission patterns EP1, EP2, and EP3, respectively, and may be formed through the same process as that of the first to third emission patterns EP1, EP2, and EP3. Each of the first dummy patterns DMP1 may be simultaneously formed with a corresponding emission pattern through one process, and may be formed separately from the corresponding emission pattern by the undercut shape of the partition PW.

FIG. 5A shows that the inner surface of the 1-1 dummy pattern D11 defining the 1-1 dummy opening OP1-D is aligned with the inner surface of the second layer L2 defining the second area A2 (refer to FIG. 9C) of the first partition opening OP1-P and the inventive concept is not limited thereto, and the 1-1 dummy pattern D11 may cover the inner surface of the second layer L2. This description may be similarly applied to the 1-2 and 1-3 dummy patterns D12 and D13.

The second dummy patterns DMP2 may be disposed on the first dummy patterns DMP1. The second dummy patterns DMP2 may include a 2-1 dummy pattern D21, a 2-2 dummy pattern D22, and a 2-3 dummy pattern D23. Openings may be defined in the 2-1 to 2-3 dummy patterns D21, D22, and D23, respectively, and may extend from the 1-1 to 1-3 dummy openings OP1-D, OP2-D, and OP3-D, respectively, to define an integral opening space. The 2-1 to 2-3 dummy patterns D21, D22, and D23 may have closed-line shapes enclosing the first to third emission areas PXA-R, PXA-G, and PXA-B, respectively, in the plan view.

The second dummy patterns DMP2 may include a conductive material. The 2-1 to 2-3 dummy patterns D21, D22, and D23 may include the same material as that of the first to third cathodes CE1, CE2, and CE3. The 2-1 to 2-3 dummy patterns D21, D22, and D23 may be formed through the same process as that of the first to third cathodes CE1, CE2, and CE3, respectively. Each of the second dummy patterns DMP2 may be simultaneously formed with the corresponding cathode through one process, or may be formed separately from the corresponding cathode by the undercut shape of the partition PW.

The encapsulation layer TFE may be disposed on the display element layer D-OL. The encapsulation layer TFE in the illustrated embodiment may include a first lower encapsulation inorganic pattern LIL1, a second lower encapsulation inorganic pattern LIL2, a third lower encapsulation inorganic pattern LIL3, a first cover layer CL1, a second cover layer CL2, an encapsulation organic layer OL, and an upper encapsulation inorganic layer UIL.

The first lower encapsulation inorganic pattern LIL1 may overlap the first emission opening OP1-E. A part of the first lower encapsulation inorganic pattern LIL1 may be disposed on the first light-emitting element ED1 inside the first partition opening OP1-P, and another part of the first lower encapsulation inorganic pattern LIL1 may be disposed on the 1-1 and 2-1 dummy patterns D11 and D21. The first lower encapsulation inorganic pattern LIL1 may cover the inner surface of each of the 1-1 and 2-1 dummy patterns D11 and D21, and the inner surface of the second layer L2 defining the second area A2 (refer to FIG. 9C) of the first partition opening OP1-P. In an embodiment, the first lower encapsulation inorganic pattern LIL1 may contact the inner surface of the first layer L1 defining the first area A1 (refer to FIG. 9C) of the first partition opening OP1-P.

The second lower encapsulation inorganic pattern LIL2 may overlap the second emission opening OP2-E. A part of the second lower encapsulation inorganic pattern LIL2 may be disposed on the second light-emitting element ED2 inside the second partition opening OP2-P, and another part of the second lower encapsulation inorganic pattern LIL2 may be disposed on the 1-2 and 2-2 dummy patterns D12 and D22. The second lower encapsulation inorganic pattern LIL2 may cover the inner surface of each of the 1-2 and 2-2 dummy patterns D12 and D22, and the inner surface of the second layer L2 defining the second area of the second partition opening OP2-P. In an embodiment, the second lower encapsulation inorganic pattern LIL2 may contact an inner surface of the first layer L1 defining the first area of the second partition opening OP2-P.

The third lower encapsulation inorganic pattern LIL3 may be overlapped with the third emission opening OP3-E. A part of the third lower encapsulation inorganic pattern LIL3 may be disposed on the third light-emitting element ED3 inside the third partition opening OP3-P, and another part of the third lower encapsulation inorganic pattern LIL3 may be disposed on the 1-3 and 2-3 dummy patterns D13 and D23. The third lower encapsulation inorganic pattern LIL3 may cover the inner surface of each of the 1-3 and 2-3 dummy patterns D13 and D23, and the inner surface of the second layer L2 defining the second area of the third partition opening OP3-P. In an embodiment, the third lower encapsulation inorganic pattern LIL3 may contact an inner surface of the first layer L1 defining the first area of the third partition opening OP3-P.

In this embodiment, the first cover layer CL1 may be disposed on the partition PW and the first and second light-emitting elements ED1 and ED2. The first cover layer CL1 may overlap the first and second emission areas PXA-R and PXA-G and the peripheral area NPXA. The first cover layer CL1 may include a first portion P1, a second portion P2, and a third portion P3.

The first portion P1 may cover the first and second lower encapsulation inorganic patterns LIL 1 and LIL2, and may cover portions of the upper surface US of the partition PW exposed from the first and second dummy patterns DMP1 and DMP2. The first portion P1 may cover the outer surface Oa of each of the first and second lower encapsulation inorganic patterns LIL1 and LIL2 and the outer surface of each of the first and second dummy patterns DMP1 and DMP2.

The second portion P2 may be disposed between the partition PW and the 1-2 dummy pattern D12. A first sub opening OP1-C corresponding to the second emission opening OP2-E may be defined in the second portion P2. An inner surface of the first cover layer CL1 defining the first sub opening OP1-C may be covered by the second lower encapsulation inorganic pattern LIL2. Part of the first portion P1 may be disposed on the second portion P2.

The third portion P3 may be disposed between the partition PW and the 1-3 dummy pattern D13. A second sub opening OP2-C corresponding to the third emission opening OP3-E may be defined in the third portion P3. An inner surface of the first cover layer CL1 defining the second sub opening OP2-C may be covered by the third lower encapsulation inorganic pattern LIL3.

In this embodiment, the 1-1 dummy pattern D11 contacts the upper surface US of the partition PW and is disposed on the partition PW, but the 1-2 dummy pattern D12 may be disposed on the second portion P2 of the first cover layer CL1 and spaced apart from the partition PW, and the 1-3 dummy pattern D13 may be disposed on the third portion P3 of the first cover layer CL1 and spaced apart from the partition PW.

In this specification, the first to third portions P1, P2, and P3 are defined by dividing the area of the first cover layer CL1 for convenience of description, and substantially constitute one structure. That is, the first to third portions P1, P2, and P3 may form an integral shape.

In FIG. 6, the first portion P1 of the first cover layer CL1 is lightly displayed and the second and third portions P2 and P3 of the first cover layer CL1 are displayed boldly, and the second cover layer CL2 is indicated by hatching. As shown in FIG. 6, each of the plurality of second portions P2 may have a closed-line shape enclosing the corresponding second emission area PXA-G in a plan view. Each of the plurality of third portions P3 may have a closed-line shape enclosing the corresponding third emission area PXA-B in a plan view. In a plan view, the first portion P1 may overlap the second portion P2, the third portion P3, and the first sub opening OP1-C defined in the second portion P2.

The second cover layer CL2 may be disposed on the partition PW adjacent to the third light-emitting element ED3 and the third emission area PXA-B. The second cover layer CL2 may overlap the third emission area PXA-B and the peripheral area NPXA adjacent thereto. The second cover layer CL2 may be a portion disposed on the third lower encapsulation inorganic pattern LIL3, a portion of the second cover layer CL2 may be disposed within the third partition opening OP3-P, and another portion of the second cover layer CL2 may be disposed on the 1-3 and 2-3 dummy patterns D13 and D23. The second cover layer CL2 may overlap the inner surface of each of the 1-3 and 2-3 dummy patterns D13 and D23, and the inner surface of the first cover layer CL1 defining the second sub opening OP2-C.

As shown in FIG. 6, the plurality of second cover layers CL2 may be provided in a pattern shape. Each of the second cover layers CL2 may overlap the corresponding third emission area PXA-B in a plan view. Portions of the second cover layer CL2 disposed on the partition PW may overlap the third portions P3 of the first cover layer CL1 in a plan view. Portions of the second cover layer CL2 disposed on the third light-emitting element ED3 may overlap the second sub openings OP2-C defined in the third portions P3 in a plan view.

In this embodiment, the second cover layer CL2 may include the same material as that of the first cover layer CL1. In an embodiment, each of the first and second cover layers CL1 and CL2 may include a transparent conductive oxide, for example.

In the illustrated embodiment, since the first and second cover layers CL1 and CL2 are included, outer surfaces of the dummy patterns DMP1 and DMP2 may not be exposed during the removal process of the photoresist layer. Accordingly, damage to the dummy patterns DMP1 and DMP2 may be prevented, and thus the display panel DP with improved process reliability may be provided. A detailed description of this will be described later.

In this embodiment, a difference in refractive index between the first and second cover layers CL1 and CL2 and the first to third lower encapsulation inorganic patterns LIL1, LIL2, and LIL3 may be about 0.4 or less. In an embodiment, the first and second cover layers CL1 and CL2 may have a refractive index of about 1.5 to about 2.0. The refractive index of the first and second cover layers CL1 and CL2 may be values respect to light with a wavelength of about 633 nm. The first and second cover layers CL1 and CL2 may have a refractive index similar to that of the first to third lower encapsulation inorganic patterns LIL1, LIL2, and LIL3, and in the process of emitting light provided from the light-emitting elements ED1, ED2, and ED3, a change in the light path may be minimized. In an embodiment, the first to third lower encapsulation inorganic patterns LIL1, LIL2, and LIL3 may have a refractive index of about 1.6 to about 1.8, and in this case, the first and second cover layers CL1 and CL2 may have a refractive index of about 1.5 to about 2.0, and preferably, the first and second cover layers CL1 and CL2 may have a refractive index of about 1.6 to about 1.8, for example. Therefore, in the illustrated embodiment, even when the first and second cover layers CL1 and CL2 are included, light extraction efficiency of the light-emitting elements ED1, ED2, and ED3 may be prevented from being reduced.

The encapsulation organic layer OL may cover the first and second cover layers CL1 and CL2 and provide a flat upper surface. An upper encapsulation inorganic layer UIL may be disposed on the encapsulation organic layer OL.

The first to third lower encapsulation inorganic patterns LIL1, LIL2, and LIL3 and the upper encapsulation inorganic layer UIL may protect the display element layer D-OL from moisture/oxygen, and the encapsulation organic layer OL may protect the display element layer D-OL from foreign substances such as dust particles.

As shown in FIG. 5B, the display panel DP-1 in another embodiment of the inventive concept may further include first to third capping patterns CP1, CP2, and CP3. The first to third capping patterns CP1, CP2, and CP3 may be disposed on the first to third cathodes CE1, CE2, and CE3, respectively, and may be disposed within the first to third partition openings OP1-P, OP2-P, and OP3-P.

The first to third capping patterns CP1, CP2, and CP3 may include at least one of an inorganic layer and an organic layer. The first to third capping patterns CP1, CP2, and CP3 may protect the light-emitting elements ED1, ED2, and ED3 disposed therebelow. In an embodiment, the first to third capping patterns CP1, CP2, and CP3 may be insulating layers having a predetermined refractive index, and may improve light extraction efficiency of the light-emitting elements ED 1, ED2, and ED3. Also, in this embodiment, a difference between the refractive indices of the first and second cover layers CL1 and CL2 and the refractive indices of the first to third capping patterns CP1, CP2, and CP3 may be 0.4 or less. The first and second cover layers CL1 and CL2 may have a refractive index similar to that of the first to third capping patterns CP1, CP2, and CP3, and in the process of emitting light provided from the light-emitting elements ED1, ED2, and ED3, a change in the light path may be minimized.

Also, the display panel DP-1 in an embodiment may further include third dummy patterns DMP3. The third dummy patterns DMP3 may include a 3-1 dummy pattern D31, a 3-2 dummy pattern D32, and a 3-3 dummy pattern D33. The 3-1 to 3-3 dummy patterns D31, D32, and D33 may be disposed between the 2-1 to 2-3 dummy patterns D21, D22, and D23 and the first to third lower encapsulation inorganic patterns LIL1, LIL2, and LIL3, respectively.

Openings may be defined in the 3-1 to 3-3 dummy patterns D31, D32, and D33, respectively, and the openings defined in the 3-1 to 3-3 dummy patterns D31, D32, and D33 may extend from the openings defined in the 2-1 to 2-3 dummy patterns D21, D22, and D23, respectively, to define an integral opening space with the 1-1 to 1-3 dummy openings OP1-D, OP2-D, and OP3-D. The 3-1 to 3-3 dummy patterns D31, D32, and D33 may have closed-line shapes enclosing the first to third emission areas PXA-R, PXA-G, and PXA-B, respectively, in the plan view.

The 3-1 to 3-3 dummy patterns D31, D32, and D33 may include the same material as that of the first to third capping patterns CP1, CP2, and CP3, respectively. Each of the 3-1 to 3-3 dummy patterns D31, D32, and D33 may be simultaneously formed with the corresponding capping pattern through one process, and may be formed separately from the corresponding capping pattern by the undercut shape of the partition PW.

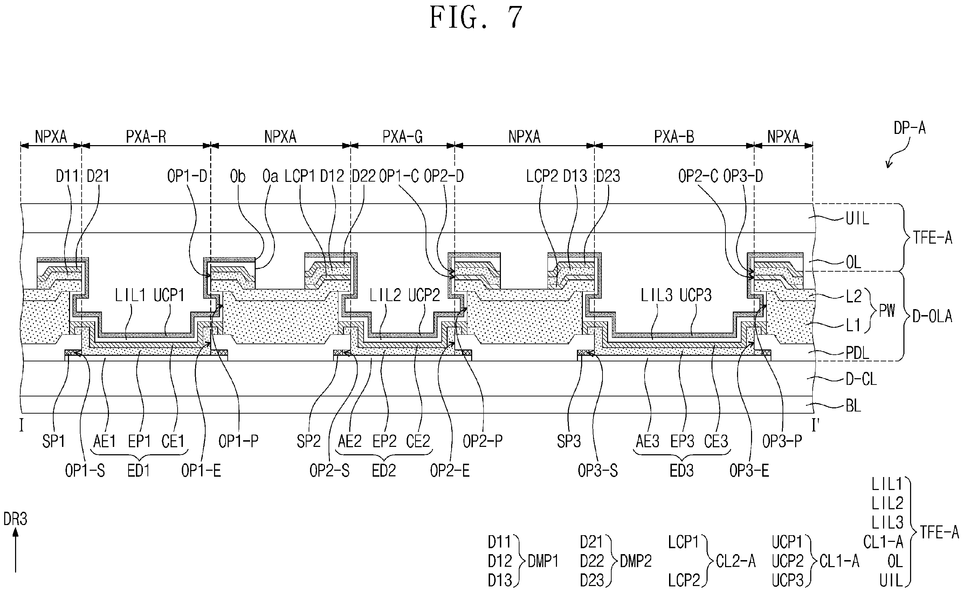

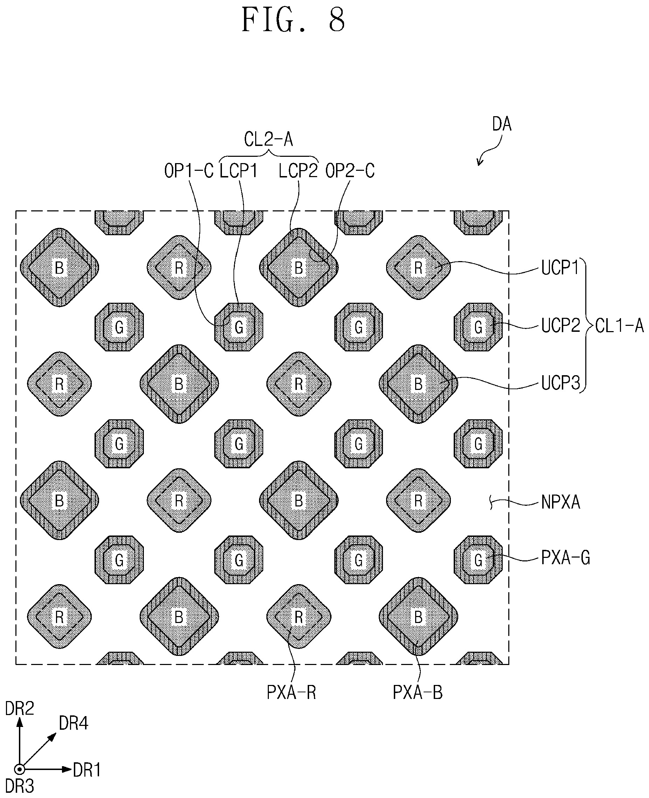

FIG. 7 is a cross-sectional view of a display panel in an embodiment taken along line I-I' of FIG. 4. FIG. 8 is an enlarged plan view of some components of a display panel according to the inventive concept.

Referring to FIG. 7, a display panel DP-A in an embodiment includes a base layer BL, a circuit element layer D-CL, a display element layer D-OLA, and an encapsulation layer TFE-A. The display element layer D-OLA in the illustrated embodiment may include light-emitting elements ED1, ED2, and ED3, a pixel defining layer PDL, a partition PW, a lower cover layer CL2-A (hereinafter also referred to as a second cover layer), and dummy patterns DMP1 and DMP2. The encapsulation layer TFE-A in the illustrated embodiment may include first to third lower encapsulation inorganic patterns LIL1, LIL2, and LIL3, an upper cover layer CL1-A (hereinafter also referred to as a first cover layer), an encapsulation organic layer OL, and an upper encapsulation inorganic layer UIL. The base layer BL and the circuit element layer D-CL may be applied in the same manner as described above with reference to FIGS. 5A and 5B, and hereinafter, differences in the display element layer D-OLA and the encapsulation layer TFE-A will be mainly described.

In this embodiment, the second cover layer CL2-A may include a first lower cover pattern LCP1 and a second lower cover pattern LCP2.

The first lower cover pattern LCP1 may be disposed between the partition PW and the 1-2 dummy pattern D12. A first sub opening OP1-C corresponding to the second emission opening OP2-E may be defined in the first lower cover pattern LCP 1. An inner surface of the first lower cover pattern LCP 1 defining the first sub opening OP1-C may be covered by the second lower encapsulation inorganic pattern LIL2.

In an embodiment, the inner surface of the first lower cover pattern LCP1 defining the first sub opening OP1-C may be substantially aligned with the inner surface of the 1-2 dummy pattern D12 defining the 1-2 dummy opening OP2-D. Also, an outer surface of the first lower cover pattern LCP1 may be substantially aligned with an outer surface of the 1-2 dummy pattern D12.

The second lower cover pattern LCP2 may be disposed between the partition PW and the 1-3 dummy patterns D13. A second sub opening OP2-C corresponding to the third emission opening OP3-E may be defined in the second lower cover pattern LCP2. An inner surface of the second lower cover pattern LCP2 defining the second sub opening OP2-C may be covered by the third lower encapsulation inorganic pattern LIL3.

In an embodiment, the inner surface of the second lower cover pattern LCP2 defining the second sub opening OP2-C may be substantially aligned with the inner surface of the 1-3 dummy pattern D13 defining the 1-3 dummy opening OP3-D. Also, an outer surface of the second lower cover pattern LCP2 may be substantially aligned with an outer surface of the 1-3 dummy patterns D13.

In this embodiment, the second cover layer CL2-A may include at least one of an inorganic layer and a carbon layer. In an embodiment, the inorganic layer may include silicon nitride or silicon oxide, for example.

In this embodiment, the first and second lower cover patterns LCP1 and LCP2 may be formed from a protective layer provided to cover an organic pattern (e.g., the 1-2 and 1-3 dummy patterns D12 and D13) including a side surface exposed during the manufacturing process of the display panel DP. Through the etching process that proceeds after the formation of the protective layer, some of the protective layer may remain in the final product without being etched, and the first and second lower cover patterns LCP1 and LCP2 may correspond to the remainder of the protective layer.

According to this embodiment, as the side surface of the exposed organic pattern is covered, damage in a subsequent process may be prevented, and thus the display panel DP-A with improved process reliability may be provided. A detailed description of this will be described later.

The first cover layer CL1-A may include a first upper cover pattern UCP1, a second upper cover pattern UCP2, and a third upper cover pattern UCP3.

The first upper cover pattern UCP1 may be disposed on the first lower encapsulation inorganic pattern LIL1 and may overlap the first emission opening OP1-E. A part of the first upper cover pattern UCP1 may be disposed within the first partition opening OP1-P, and another part of the first upper cover pattern UCP1 may be disposed on the partition PW. The first upper cover pattern UCP1 may overlap the inner surface of the 1-1 dummy pattern D11. An outer surface Ob of the first upper cover pattern UCP1 may be substantially aligned with an outer surface Oa of the first lower encapsulation inorganic pattern LIL1.

The second upper cover pattern UCP2 may be disposed on the second lower encapsulation inorganic pattern LIL2 and may overlap the second emission opening OP2-E. A part of the second upper cover pattern UCP2 may be disposed within the second partition opening OP2-P, and another part of the second upper cover pattern UCP2 may be disposed on the partition PW. The second upper cover pattern UCP2 may overlap the inner surface of the 1-2 dummy pattern D12 and the inner surface of the first lower cover pattern LCP1. An outer surface of the second upper cover pattern UCP2 may be substantially aligned with an outer surface of the second lower encapsulation inorganic pattern LIL2.

The third upper cover pattern UCP3 may be disposed on the third lower encapsulation inorganic pattern LIL3 and may overlap the third emission opening OP3-E. A part of the third upper cover pattern UCP3 may be disposed within the third partition opening OP3-P, and another part of the third upper cover pattern UCP3 may be disposed on the partition PW. The third upper cover pattern UCP3 may overlap the inner surface of the 1-3 dummy pattern D13 and the inner surface of the second lower cover pattern LCP2. An outer surface of the third upper cover pattern UCP3 may be substantially aligned with an outer surface of the third lower encapsulation inorganic pattern LIL3.

According to this embodiment, by including the first cover layer CL1-A, the outer surfaces of the dummy patterns DMP1 and DMP2 are exposed after the photoresist layer removal process, so that during the process of removing the photoresist layer, damage to the dummy patterns DMP1 and DMP2 may be prevented, and thus the display panel DP-A with improved process reliability may be provided. A detailed description of this will be described later.

In FIG. 8, the first and second lower cover patterns LCP1 and LCP2 are indicated by hatching, and the first to third upper cover patterns UCP1, UCP2 and UCP3 are indicated in bold. As shown in FIG. 8, each of the plurality of first and second lower cover patterns LCP1 and LCP2 may be provided in a pattern form, and each of the plurality of first to third upper cover patterns UCP1, UCP2, and UCP3 may be provided in a pattern form.

In a plan view, each of the first lower cover patterns LCP1 may have a closed-line shape surrounding the corresponding second emission area PXA-G, and each of the second lower cover patterns LCP2 may have a closed-line shape surrounding the corresponding third emission area PXA-B.

In a plan view, the first to third upper cover patterns UCP1, UCP2, and UCP3 may overlap the first to third emission areas PXA-R, PXA-G, and PXA-B, respectively. In a plan view, each of the second upper cover patterns UCP2 may overlap the corresponding first lower cover pattern LCP 1, and each of the third upper cover patterns UCP3 may overlap the corresponding second lower cover pattern LCP2.

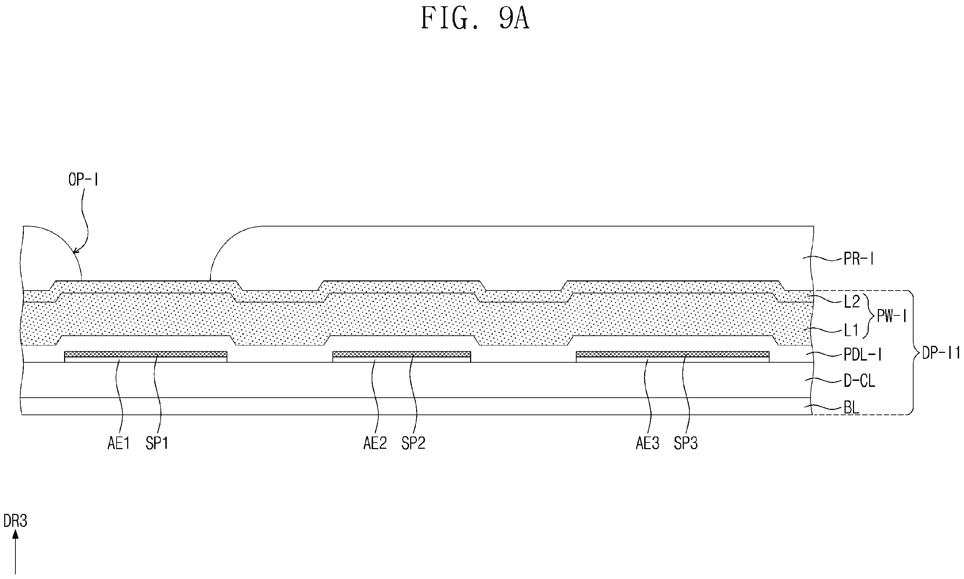

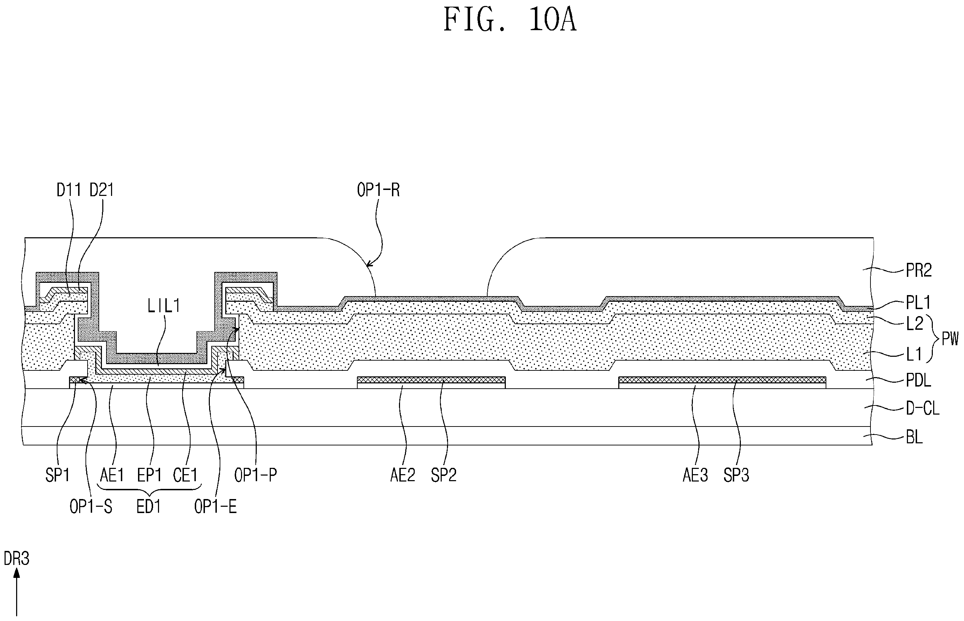

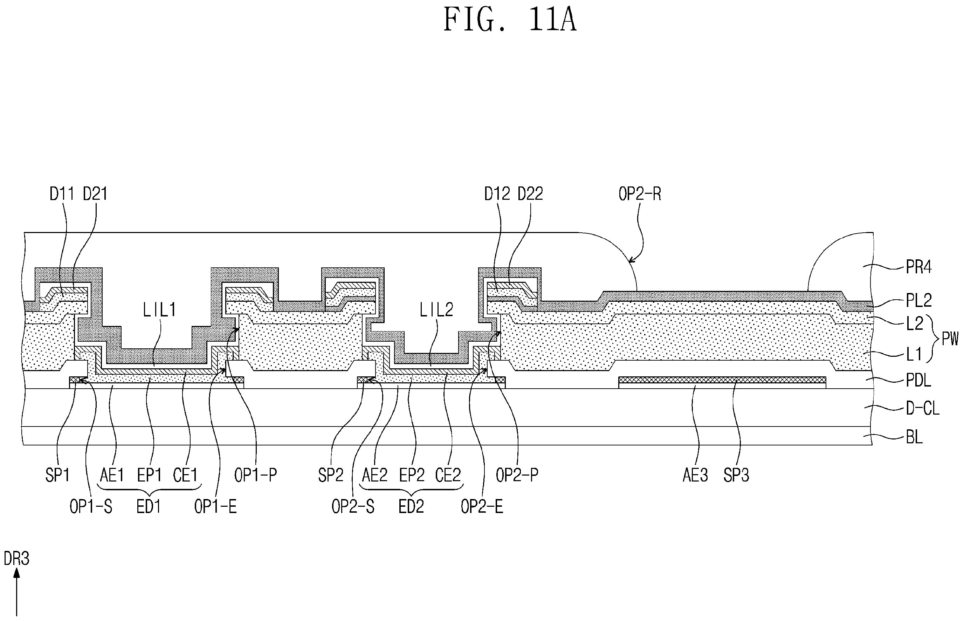

FIGS. 9A to 9J are cross-sectional views illustrating an embodiment of some of operations in a method of manufacturing a display panel according to the inventive concept. FIGS. 10A to 10H are cross-sectional views illustrating an embodiment of some of operations in a method of manufacturing a display panel according to the inventive concept. FIGS. 11A to 11G are cross-sectional views illustrating an embodiment of some of operations in a method of manufacturing a display panel according to the inventive concept. In the description with reference to FIGS. 9A to 11G, the same/similar reference numerals are used for the same/similar configurations as those described with reference to FIGS. 1A to 6, and redundant descriptions are omitted.

The display panel manufacturing method according to the inventive concept includes providing a preliminary display panel including a base layer, a first anode disposed on the base layer, a pixel defining layer disposed on the base layer and defining a first emission opening exposing a portion of the first anode, and a partition disposed on the pixel defining layer and defining a first partition opening corresponding to the first emission opening, forming a first emission pattern within the first emission opening and the first partition opening, forming a first cathode on the first emission pattern, forming a first mask pattern on the first cathode and a portion of the partition adjacent to the first partition opening, etching using the first mask pattern, and forming a first protective layer on the first light-emitting element and the partition. In the operation of forming the first emission pattern, a 1-1 dummy layer including the same material as that of the first emission pattern and disposed on the partition is formed, and in the operation of etching using the first mask pattern, a 1-1 dummy pattern is formed from the 1-1 dummy layer, and the first protective layer covers an outer surface of the 1-1 dummy pattern.

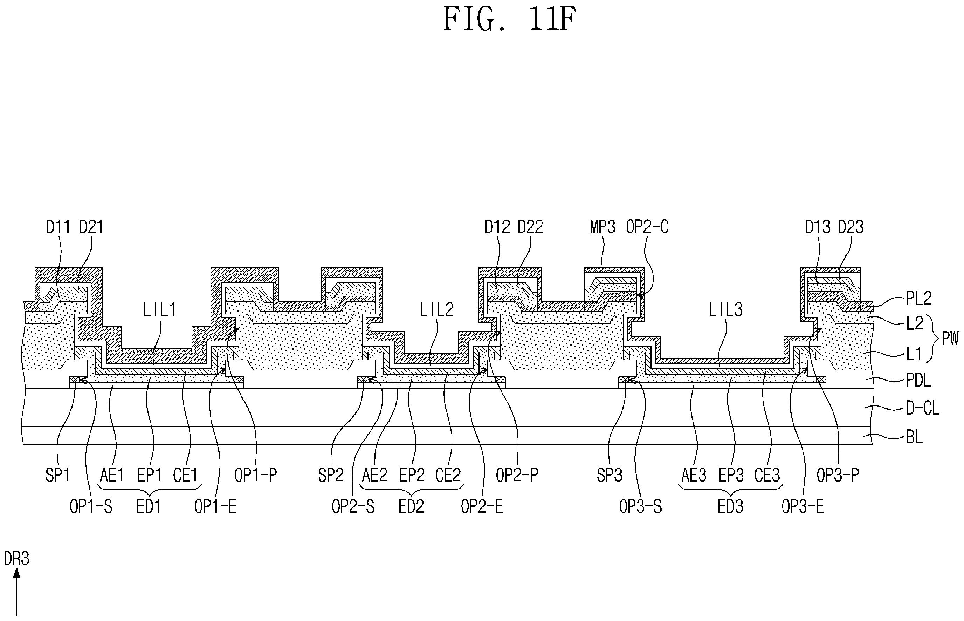

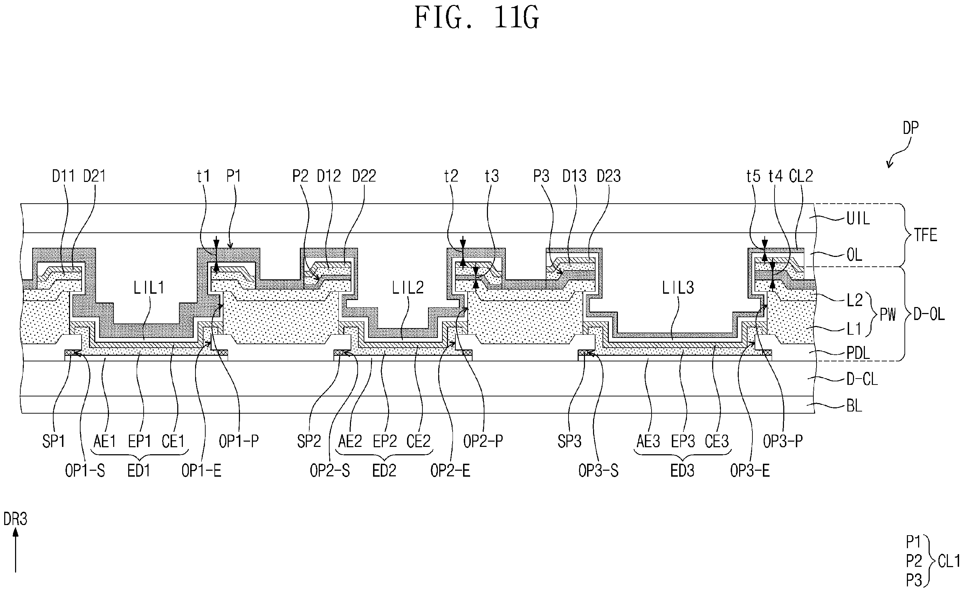

The display panel manufacturing method according to the inventive concept may include a first group process, a second group process, a third group process, and a fourth group process. The first to third group processes may be processes of forming some components of the first to third light-emitting elements ED1, ED2, and ED3 (refer to FIG. 11F) and the encapsulation layer TFE (refer to FIG. 11G), respectively, and the fourth group process may be a process of completing the display panel DP (refer to FIG. 11G) by forming the remaining components of the encapsulation layer TFE (refer to FIG. 11G).

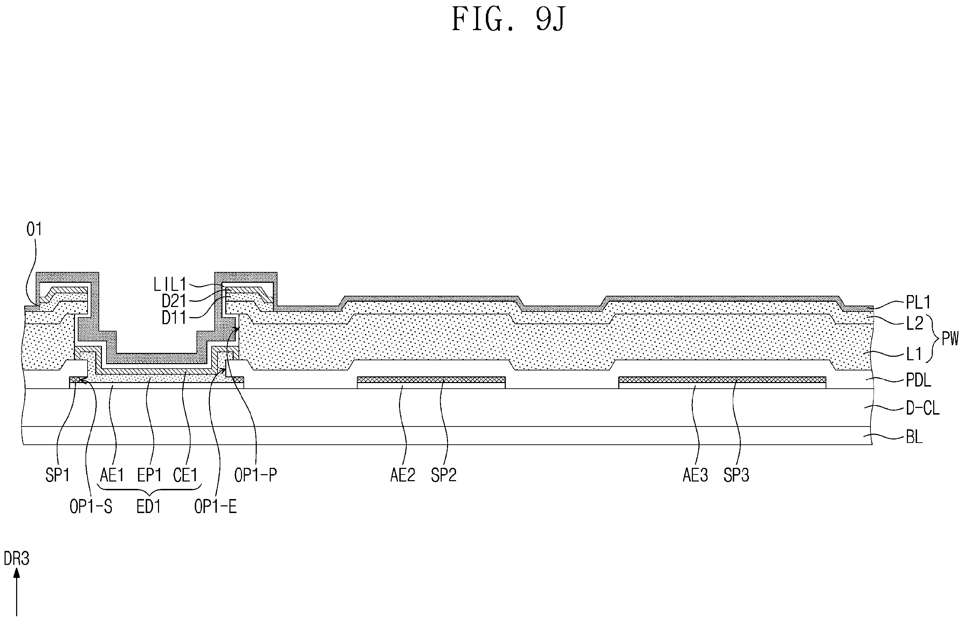

In this embodiment, through the first group process, the first light-emitting element ED1 (refer to FIG. 9J) and the first lower encapsulation inorganic pattern LIL1 (refer to FIG. 9J) covering the first light-emitting element ED1 may be formed. Hereinafter, the first group process will be described with reference to FIGS. 9A to 9J.

Referring to FIG. 9A, the first group process in the illustrated embodiment may include forming an initial photoresist layer PR-I on the first preliminary display panel DP-I1.

The first preliminary display panel DP-I1 provided in this embodiment may include a base layer BL, a circuit element layer D-CL, first to third anodes AE1, AE2, and AE3, first to third sacrificial patterns SP1, SP2, and SP3, a preliminary pixel defining layer PDL-I, and a preliminary partition layer PW-I.

The circuit element layer D-CL may be formed through a typical circuit device manufacturing process for forming semiconductor patterns, conductive patterns, and signal lines by forming an insulating layer, a semiconductor layer, and a conductive layer through methods such as coating and deposition, and selectively patterning the insulating layer, semiconductor layer, and conductive layer through photolithography and etching processes.

The first to third anodes AE1, AE2, and AE3 and the first to third sacrificial patterns SP1, SP2, and SP3 may be formed by the same patterning process. The preliminary pixel defining layer PDL-I may cover all of the first to third anodes AE1, AE2, and AE3 and the first to third sacrificial patterns SP1, SP2, and SP3.

The preliminary partition layer PW-I may include a first layer L1 and a second layer L2 disposed on the first layer L1. The first layer L1 may have a first conductivity and a first thickness, and the second layer L2 may have a second conductivity lower than the first conductivity and a second thickness smaller than the first thickness.

The initial photoresist layer PR-I may be formed by forming a preliminary photoresist layer on the preliminary partition layer PW-I and then patterning the preliminary photoresist layer using a photo mask. Through the patterning process, an initial opening OP-I overlapping the first anode AE1 may be defined in the initial photoresist layer PR-I.

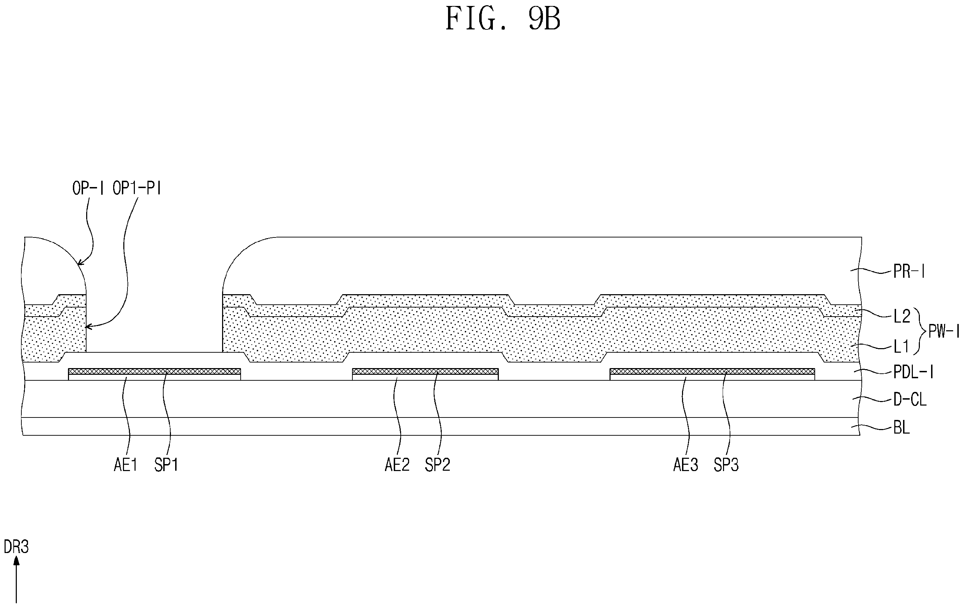

Then, referring to FIGS. 9B and 9C, the first group process in the illustrated embodiment may include forming a partition PW in which the first partition opening OP1-P is defined from the preliminary partition layer PW-I through the first etching process.

First, as shown in FIG. 9B, the first etching process may include defining the first preliminary partition opening OP1-PI in the preliminary partition layer PW-I by the initial photoresist layer PR-I as a mask and dry etching the first and second layers L1 and L2. The dry etching of the first etching process may be performed in an etching environment in which the etching selectivity between the first and second layers L1 and L2 is substantially the same. Accordingly, the inner surface of the first layer L1 and the inner surface of the second layer L2 defining the first preliminary partition opening OP1-PI may be substantially aligned.

Then, as shown in FIG. 9C, the first etching process may include defining the first partition opening OP1-P from the first preliminary partition opening OP1-PI by the initial photoresist layer PR-I as a mask and wet etching the first and second layers L1 and L2. Through this, the partition PW may be formed from the preliminary partition layer PW-I in which the first preliminary partition opening OP1-PI is defined. The first partition opening OP1-P may include a first area A1 defined by the first inner surface I1 of the first layer L1 and a second area A2 defined by the second inner surface I2 of the second layer L2.

The wet etching process in the first etching process may be performed in an environment where the etching selectivity between the first and second layers L1 and L2 is substantially high. Accordingly, an inner surface of the partition PW defining the first partition opening OP1-P may have an undercut shape in cross section. Specifically, as the etch rate of the first layer L1 with respect to the etching solution is greater than that of the second layer L2, the first layer L1 may be mainly etched. Accordingly, the first inner surface I1 of the first layer L1 may be formed to be more recessed inward than the second inner surface I2 of the second layer L2. A tip portion may be formed in the partition PW by a portion of the second layer L2 protruding from the first layer L1.

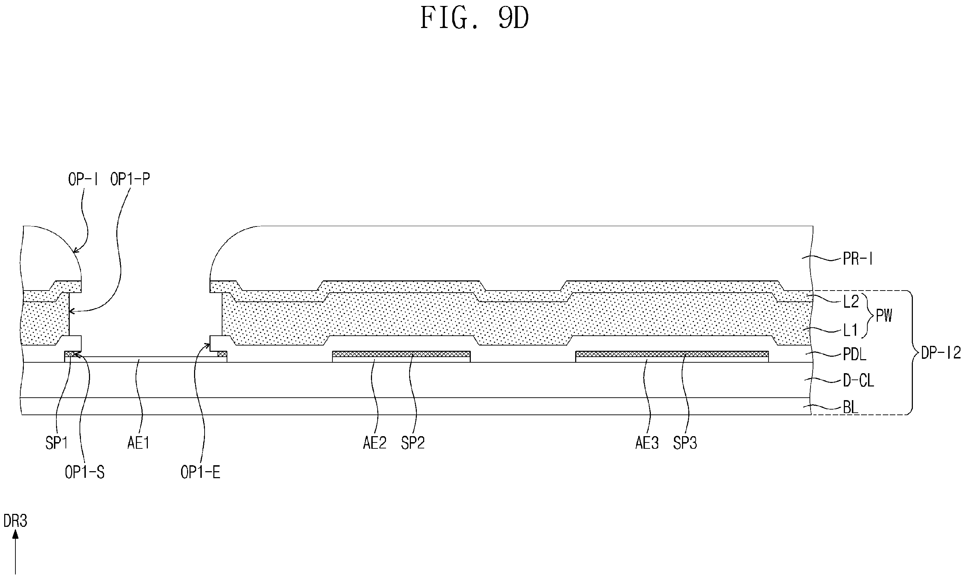

Referring to FIG. 9D, the first group process in the illustrated embodiment may include forming a pixel defining layer PDL in which a first emission opening OP1-E is defined by patterning a preliminary pixel defining layer PDL-I (refer to FIG. 9C) through a second etching process. The second etching process may be performed in a dry etching method, and may be performed using the initial photoresist layer PR-I and the partition PW (e.g., the second layer L2) as a mask.

Also, the first group process in the illustrated embodiment may include defining the first sacrificial opening OP1-S in the first sacrificial pattern SP1 to expose at least a portion of the first anode AE1 through the third etching process. The third etching process of the first group process may be performed in a wet etching method, and may be performed using an initial photoresist layer PR-I and a pixel defining layer PDL in which a first emission opening OP1-E is defined as a mask.

The inner surface of the first sacrificial pattern SP1 defining the first sacrificial opening OP1-S may be formed by sinking inward from the inner surface of the pixel defining layer PDL defining the first emission opening OP1-E. This is shown in an embodiment, and the inner surface of the first sacrificial pattern SP1 may be aligned with the inner surface of the pixel defining layer PDL, and is not limited to any particular embodiment.

The third etching process may be performed in an environment where the etching selectivity between the first sacrificial pattern SP1 and the first anode AE1 is substantially high, and through this, it is possible to prevent the first anode AE1 from being etched together. That is, by disposing the first sacrificial pattern SP1 having a higher etch rate than that of the first anode AE1 between the pixel defining layer PDL and the first anode AE1, it is possible to prevent the first anode AE1 from being etched and damaged during the etching process.

The third etching process may be performed as an etching process separate from the second etching process, or may be performed as the same etching process as the second etching process.

Then, the first group process in the illustrated embodiment may include removing the initial photoresist layer PR-I. In this specification, after the operation of removing the initial photoresist layer PR-I, it may be seen that the second preliminary display panel DP-I2 (also referred to as a preliminary display panel) is provided. That is, the second preliminary display panel DP-I2 may include a base layer BL, a circuit element layer D-CL, first to third anodes AE1, AE2, and AE3, a first sacrificial pattern SP1 in which the first sacrificial opening OP1-S is defined, second and third sacrificial patterns SP2 and SP3, a pixel defining layer PDL in which the first emission opening OP1-E is defined, and a partition PW in which the first partition openings OP1-P are defined.

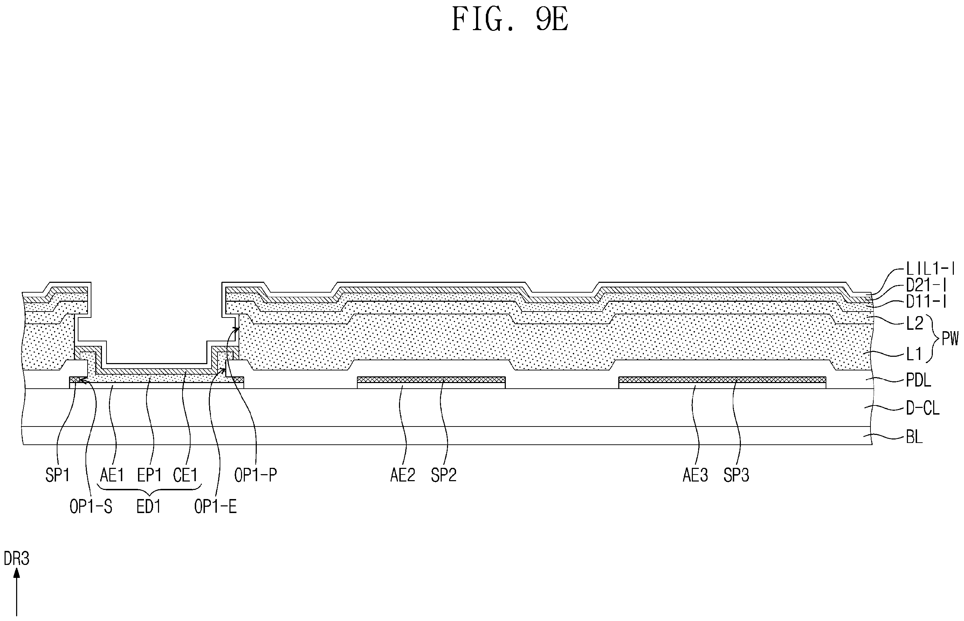

Referring to FIG. 9E, the first group process in the illustrated embodiment may include forming a first emission pattern EP1, forming a first cathode CE1, and forming a first lower encapsulation inorganic layer LIL1-I.

In an embodiment, the first emission pattern EP1 may be formed by depositing a first organic material. In an embodiment, the first emission pattern EP1 may be formed through a thermal evaporation process, for example, but is not limited thereto. Forming the first cathode CE1 may be performed by depositing a first conductive material. In an embodiment, the first cathode CE1 may be formed through a sputtering process, for example, but is not limited thereto.

The first emission pattern EP1 is separated by a tip portion formed in the partition PW, and at least a portion thereof may be disposed within the first emission opening OP1-E and the first partition opening OP1-P. In an embodiment including the first sacrificial pattern SP1, a portion of the first emission pattern EP1 may also be disposed in the first sacrificial opening OP1-S.

The first cathode CE1 is separated by a tip portion formed in the partition PW, and at least a portion of the first cathode CE1 may be disposed within the first partition opening OP1-P. In an embodiment of the inventive concept, according to the thickness of the first to third emission patterns EP1, EP2, and EP3 or the thickness of the pixel defining layer PDL, the first cathode CE1 may be disposed within the first emission opening OP1-E and the first partition opening OP1-P, and all of the first cathode CE1 may be disposed within the first partition opening OP1-P. The first cathode CE1 is provided at a higher incident angle than that of the first emission pattern EP1, so that the first cathode CE1 may be formed to contact the inner surface of the first layer L1 defining the first area A1 (refer to FIG. 9C) of the first partition opening OP1-P.

In the operation of forming the first emission pattern EP1, a 1-1 dummy layer D11-I may also be formed on the partition PW. In the operation of forming the first cathode CE1, a 2-1 dummy layer D21-I may be formed on the partition PW.

In an embodiment, the first lower encapsulation inorganic layer LIL1-I may be formed through a chemical vapor deposition ("CVD") process. The first lower encapsulation inorganic layer LIL1-I is formed on the partition PW and the first cathode CE1, and a part of the first lower encapsulation inorganic layer LII,1-I may be formed inside the first partition opening OP1-P.

The display panel manufacturing method in the illustrated embodiment may further include forming a first capping pattern CP1 (refer to FIG. 5B) between forming the first cathode CE1 and forming the first lower encapsulation inorganic layer LIL1-I. The first capping pattern CP1 (refer to FIG. 5B) may be formed through a deposition process, and the first capping pattern CP1 (refer to FIG. 5B) may be separated by a tip portion formed in the partition PW and disposed in the first partition opening OP1-P. In addition, in the operation of forming the first capping pattern CP1 (refer to FIG. 5B), a 3-1 dummy layer may be formed together on the 2-1 dummy layer D21-I, and a 3-1 dummy layer may be patterned later to form the 3-1 dummy pattern D31 (refer to FIG. 5B).

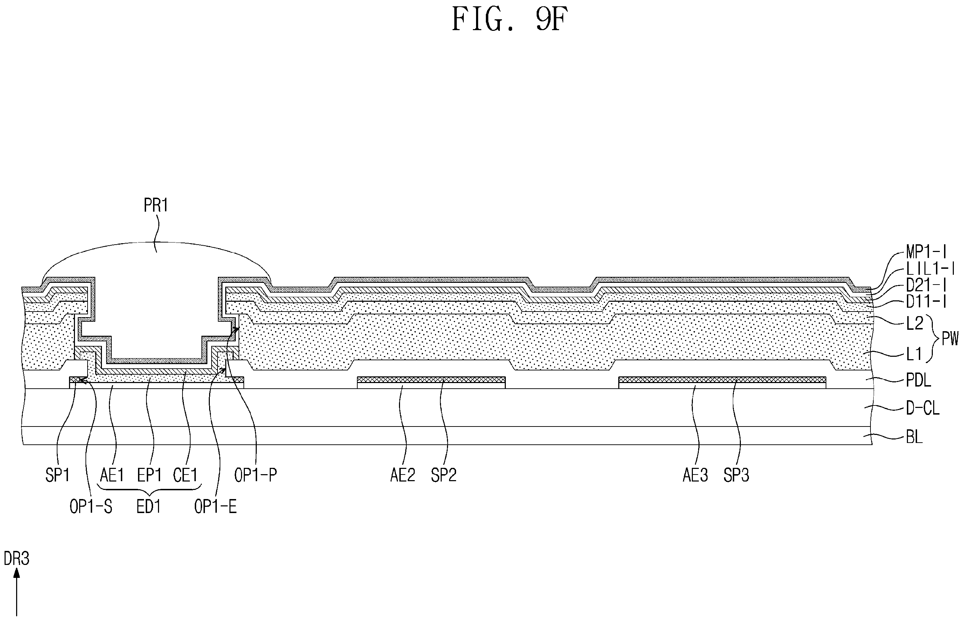

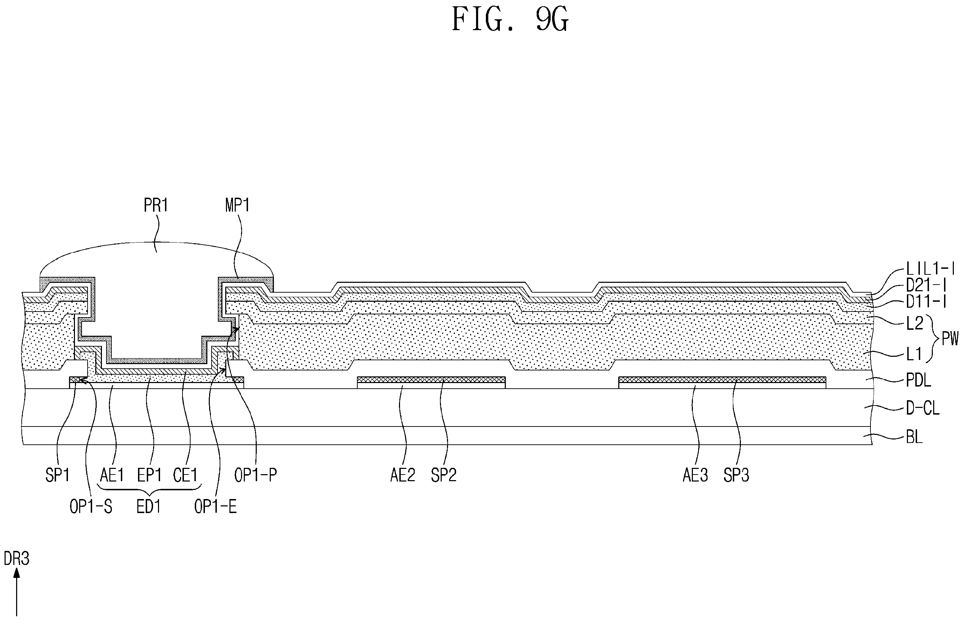

Referring to FIGS. 9F and 9G, the first group process in the illustrated embodiment may include forming a first mask pattern MP1. Forming the first mask pattern MP1 may include forming a first preliminary mask pattern MP1-I on the first lower encapsulation inorganic layer LIL1-I, forming a first photoresist layer PR1 on the first preliminary mask pattern MP1-I, and patterning the first preliminary mask pattern MP1-I so that the first mask pattern MP1 is formed from the first preliminary mask pattern MP1-I.

First, as shown in FIG. 9F, the first preliminary mask pattern MP1-I may be formed through a deposition process. In an embodiment, the first preliminary mask pattern MP1-I may be formed through a sputtering process, for example, but is not limited thereto.

In an embodiment, the first preliminary mask pattern MP1-I may include a second conductive material. The second conductive material may include a transparent conductive oxide. The transparent conductive oxide may be a material having a refractive index of about 1.5 to about 2.0. In an embodiment, the second conductive material may be indium gallium zinc oxide ("IGZO"), indium zinc oxide ("IZO"), or indium tin oxide ("ITO"), for example.

The first photoresist layer PR1 may be formed by forming a preliminary photoresist layer on the first preliminary mask pattern MP1-I and then patterning the preliminary photoresist layer using a photo mask. Through the patterning process, the first photoresist layer PR1 may be formed in a pattern shape overlapping the first emission opening OP1-E.

Then, as shown in FIG. 9G, the first preliminary mask pattern MP1-I may be patterned through a fourth etching process so that the first mask pattern MP1 is formed from the first preliminary mask pattern MP1-I.

As the first photoresist layer PR1 is used as a mask and the first preliminary mask pattern MP1-I is wet etched, in the fourth etching process, portions overlapping the second and third anodes AE2 and AE3 of the first preliminary mask pattern MP1-I may be removed. A first mask pattern MP1 overlapping the first emission opening OP1-E may be formed from the first preliminary mask pattern MP1-I from which the portion is removed. Specifically, the first mask pattern MP1 may be disposed on the first cathode CE1 and a portion adjacent to the first partition opening OP1-P of the partition PW, overlap the first anode AE1, and non-overlap the second and third anodes AE2 and AE3.

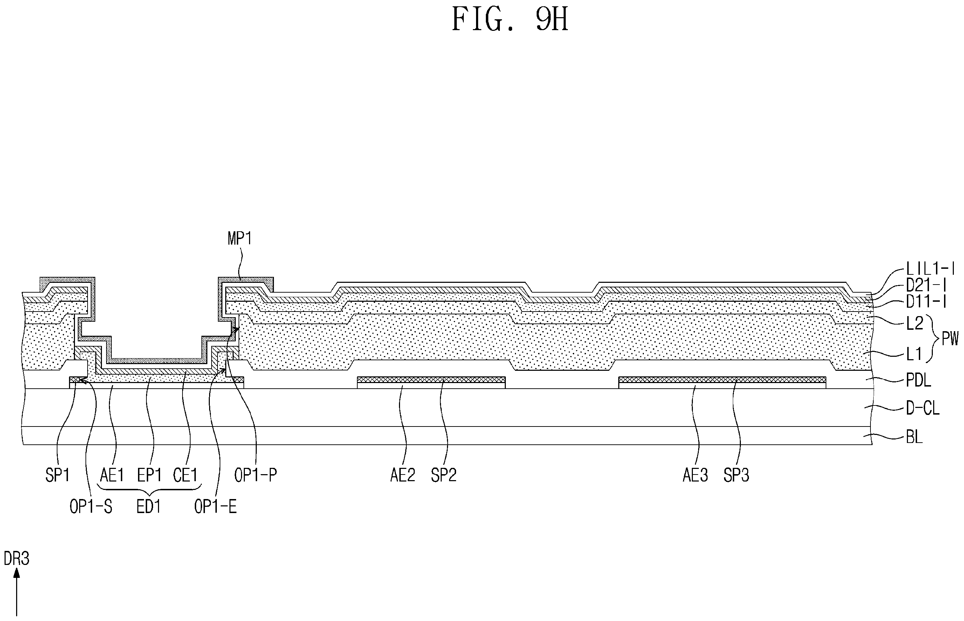

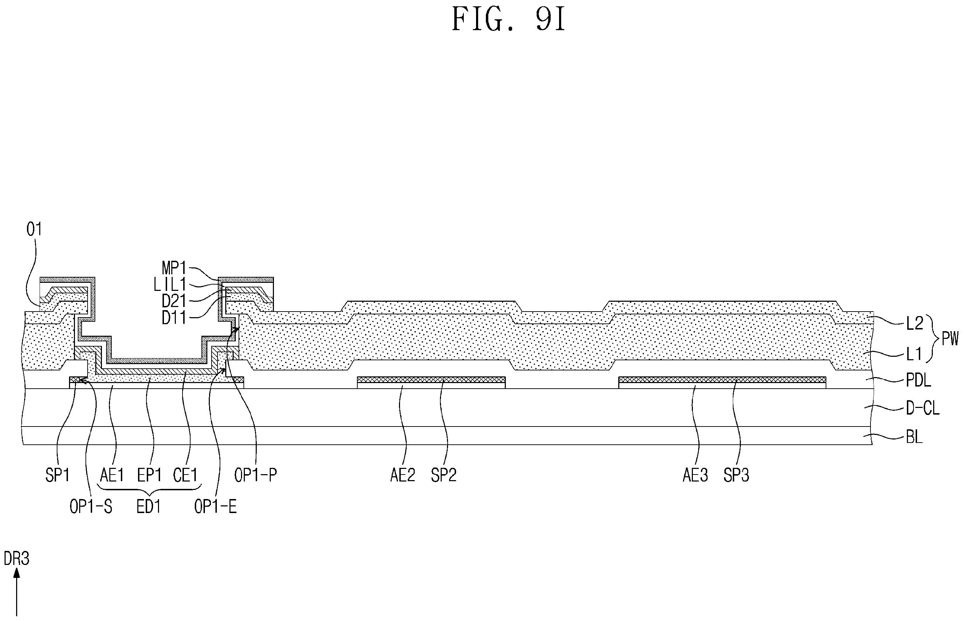

Referring to FIGS. 9H and 9I, the first group process in the illustrated embodiment may include removing the first photoresist layer PR1 (refer to FIG. 9G), patterning the first lower encapsulation inorganic layer LIL1-I through a fifth etching process, and patterning the 1-1 dummy layer D11-I through a sixth etching process.

In the illustrated embodiment, the process of removing the first photoresist layer PR1 (refer to FIG. 9G) may proceed before the patterning process of the first lower encapsulation inorganic layer LIL1-I and the patterning process of the 1-1 dummy layer D11-I.

According to the inventive concept, as the first mask pattern MP1 is provided, the first mask pattern MP1 may be used as a mask in subsequent patterning processes. Accordingly, the first photoresist layer PR1 may be removed prior to the patterning process of the first lower encapsulation inorganic layer LIL1-I and the 1-1 dummy layer D11-I. That is, the first photoresist layer PR1 may be removed before exposing the inside of the 1-1 dummy layer D11-I (i.e., the outer surface O1 of the 1-1 dummy pattern D11). Accordingly, in the process of injecting a material used to remove the photoresist layer (hereinafter also referred to as a strip solution), occurrence of physical damage that may be applied to the 1-1 dummy pattern D11 may be prevented, and it is possible to prevent part of the 1-1 dummy pattern D11 from being melted and removed by the strip solution. Therefore, lifting between the 1-1 dummy pattern D11 and the first lower encapsulation inorganic pattern LIL1 may be prevented, and by preventing foreign substances such as moisture from penetrating between the 1-1 dummy pattern D11 and the first lower encapsulation inorganic pattern LIL1, defective occurrence of the first light-emitting element ED1 may be prevented. Accordingly, it is possible to provide the first light-emitting element ED1 having improved process reliability and the display panel DP (refer to FIG. 11G) including the same.

In the first group process, through the fifth etching process, a first lower encapsulation inorganic pattern LIL1 is formed from the first lower encapsulation inorganic layer LIL1-I, and through the sixth etching process, the 1-1 dummy pattern D11 may be formed from the 1-1 dummy layer D11-I.

In the fifth etching process, a portion of the first lower encapsulation inorganic layer LIL1-I overlapping the second and third anodes AE2 and AE3 may be patterned to be removed by the first mask pattern MP1 as a mask and dry etching the first lower encapsulation inorganic layer LIL1-I. A first lower encapsulation inorganic pattern LIL1 overlapping the first emission opening OP1-E may be formed from the first lower encapsulation inorganic layer LIL1-I from which the portion is removed. A part of the first lower encapsulation inorganic pattern LIL1 may be disposed in the first partition opening OP1-P to cover the first light-emitting element ED 1, and another part of the first lower encapsulation inorganic pattern LIL1 may be disposed on the partition PW.

In the sixth etching process, portions of the 1-1 dummy layer D11-I overlapping the second and third anodes AE2 and AE3 may be removed by the first mask pattern MP1 as a mask and dry etching the 1-1 dummy layer D11-I. A 1-1 dummy pattern D11 having a closed-line shape enclosing the first emission area PXA-R (refer to FIG. 5A) in a plan view may be formed from the 1-1 dummy layer D11-I from which the portion is removed.

In the sixth etching process, the 2-1 dummy layer D21-I is also dry etched and patterned to remove portions of the 2-1 dummy layer D21-I overlapping the second and third anodes AE2 and AE3. A 2-1 dummy pattern D21 having a closed-line shape enclosing the first emission area PXA-R (refer to FIG. 5A) in a plan view may be formed from the 2-1 dummy layer D21-I from which the portion is removed. The inventive concept is not limited thereto, and the dry etching of the 2-1 dummy layer D21-I may be performed as a separate process from the dry etching process of the 1-1 dummy layer D11-I.

When the display panel manufacturing method in an embodiment further includes forming a first capping pattern CP1 (refer to FIG. 5B), in the sixth etching process, the 3-1 dummy layer is also etched together, and a portion overlapping the second and third anodes AE2 and AE3 of the 3-1 dummy layer is removed, so that the 3-1 dummy pattern D31 described above in FIG. 5B may be formed.

Referring to FIGS. 9I and 9J, the first group process in the illustrated embodiment may include forming a first protective layer PL1 from the first mask pattern MP1. The first protective layer PL1 may be formed by depositing the same material as that of the first mask pattern MP1. Accordingly, the first mask pattern MP 1 and the newly deposited material may form a first protective layer PL1. The first protective layer PL1 may overlap all of the first to third anodes AE1, AE2, and AE3. In an embodiment, in the operation of forming the first protective layer PL1, the second conductive material may be deposited by a sputtering process, for example. In an embodiment, the second conductive material may include a transparent conductive oxide, for example.

According to this embodiment, although the outer surface O1 of the 1-1 dummy pattern D11 is exposed through the sixth etching process, the exposed outer surface O1 of the 1-1 dummy pattern D11 may be covered by a first protective layer PL1 by including the operation of forming the first protective layer PL1 after the sixth etching process. Accordingly, damage to the 1-1 dummy pattern D11 may be prevented in the subsequent operation of removing the photoresist layer.

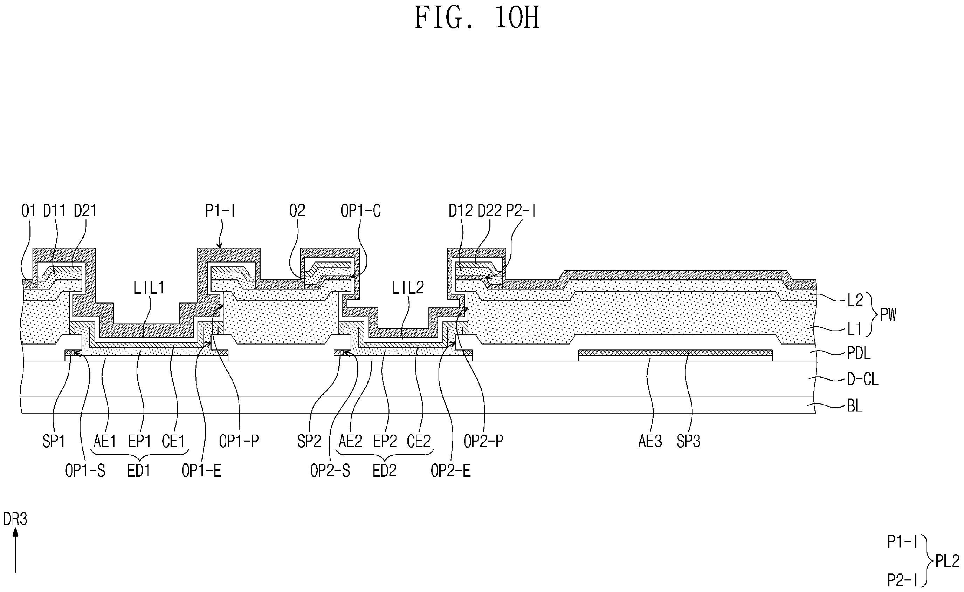

After the first group process, a second group process may be performed. In this embodiment, through the second group process, a second light-emitting element ED2 (refer to FIG. 10H) and a second lower encapsulation inorganic pattern LIL2 (refer to FIG. 10H) covering the second light-emitting element ED2 may be formed. Hereinafter, the second group process will be described with reference to FIGS. 10A to 10H.

Referring to FIG. 10A, the second group process in the illustrated embodiment may include forming a second photoresist layer PR2 on the first protective layer PL1. A first photo opening OP1-R overlapping the second anode AE2 may be defined in the second photoresist layer PR2.

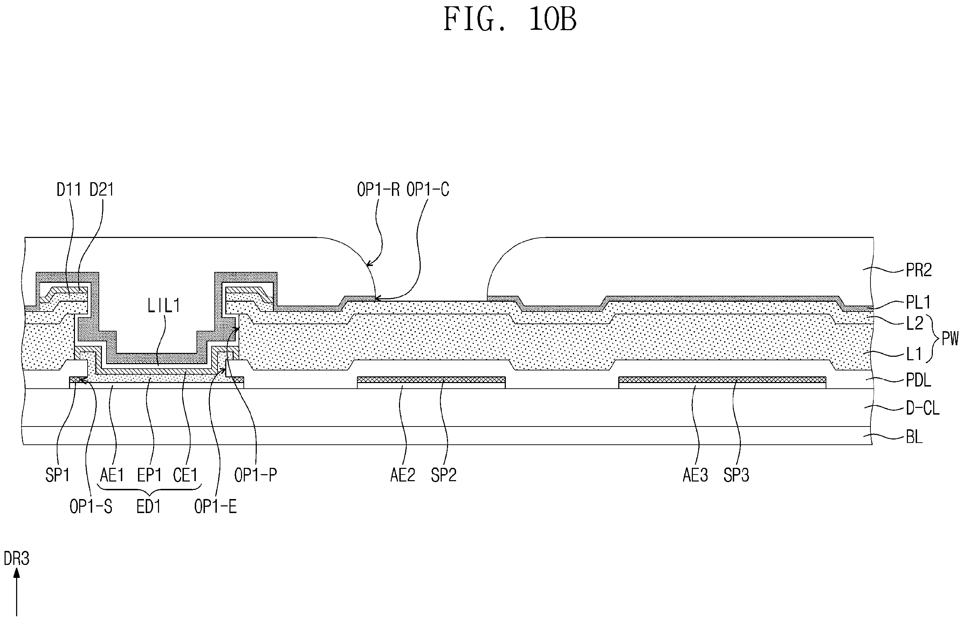

Referring to FIG. 10B, the second group process in the illustrated embodiment may include defining a first sub opening OP1-C in the first protective layer PL1 through a first etching process. In the first etching process, the first sub opening OP1-C may be formed in the first protective layer PL1 by the second photoresist layer PR2 as a mask and dry etching the first protective layer PL1. The first sub opening OP1-C corresponds to the first photo opening OP1-R and may overlap the second anode AE2.

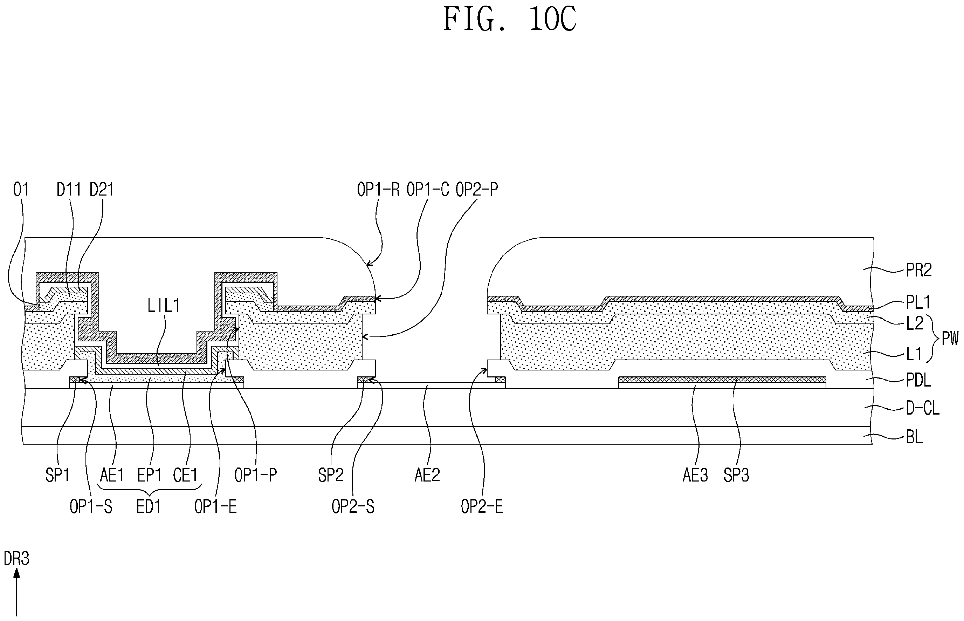

Referring to FIG. 10C, the second group process in the illustrated embodiment may include defining a second partition opening OP2-P in the partition PW through a second etching process, defining a second emission opening OP2-E in a pixel defining layer PDL through a third etching process, and defining the second sacrificial opening OP2-S in the second sacrificial pattern SP2 through a fourth etching process. At least a portion of the second anode AE2 may be exposed by the second partition opening OP2-P, the second emission opening OP2-E, and the second sacrificial opening OP2-S.

As described above with reference to FIGS. 9B and 9C, the second partition opening OP2-P may be formed through two etching processes. The second etching process may include defining the second partition opening OP2-P in the partition PW by the second photoresist layer PR2 as a mask, and dry etching and wet etching the first and second layers L1 and L2 sequentially. A detailed description of the dry etching and wet etching of the first and second layers L1 and L2 may be similarly applied to the above description. An inner surface of the partition PW defining the second partition opening OP2-P may have an undercut shape in cross section.

Defining the second emission opening OP2-E and defining the second sacrificial opening OP2-S may be performed in a manner similar to defining the first emission opening OP1-E (refer to FIG. 9D) and defining the first sacrificial opening OP1-S (refer to FIG. 9D) in the first group process, respectively. In the second group process, the third etching process may be performed using the second photoresist layer PR2 and the partition PW (e.g., the second layer L2) as a mask, and the fourth etching process may be performed using a pixel defining layer PDL in which a second emission opening OP2-E is defined as a mask.

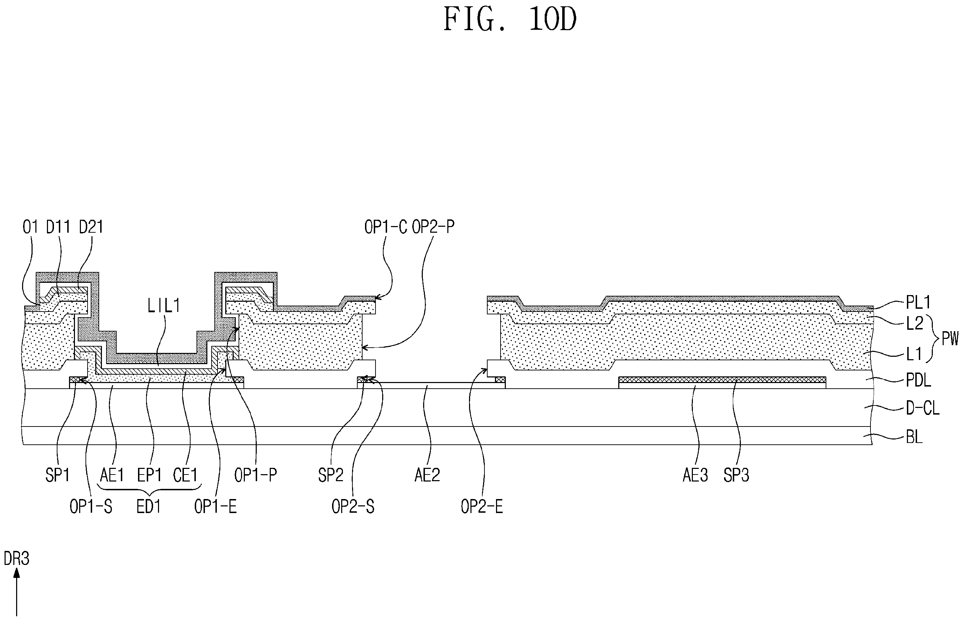

Referring to FIG. 10D, the second group process in the illustrated embodiment may include removing the second photoresist layer PR2 (refer to FIG. 10C). In this embodiment, the outer surface O1 of the 1-1 dummy pattern D11 may be provided in a state covered by the first protective layer PL1, and the 1-1 dummy pattern D11 may be prevented from being damaged by the strip solution injected to remove the second photoresist layer PR2 (refer to FIG. 10C). Accordingly, lifting of the first lower encapsulation inorganic pattern LII,1 may be prevented, and damage to the first light-emitting element ED1 may be prevented.

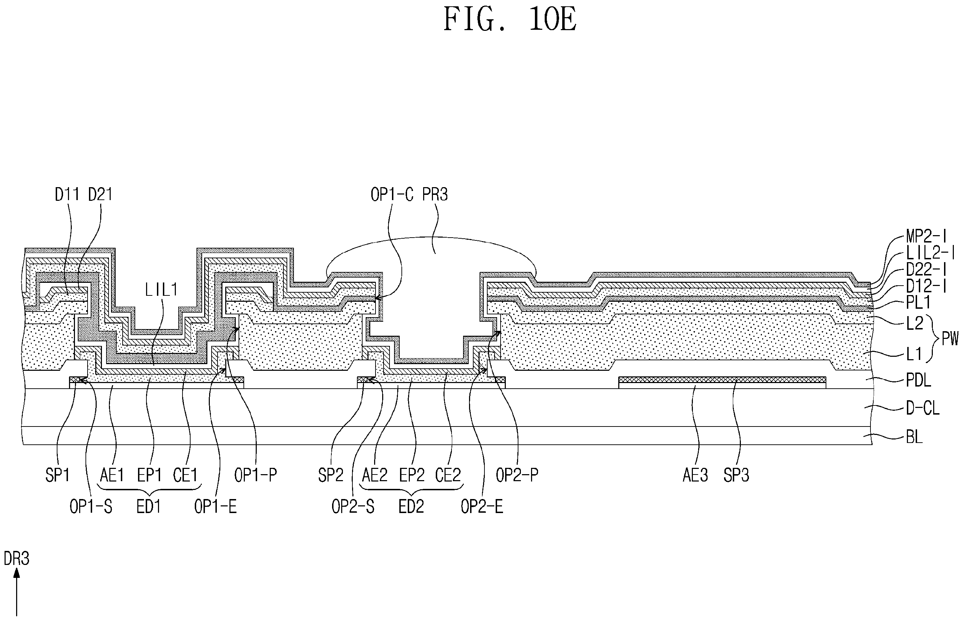

Referring to FIG. 10E, the second group process in the illustrated embodiment may include forming a second emission pattern EP2, forming a second cathode CE2, and forming a second lower encapsulation inorganic layer LIL2-I.

The forming of the second emission pattern EP2 may be performed in a manner similar to the forming of the first emission pattern EP1 in the first group process (refer to FIG. 9E). In an embodiment, the second emission pattern EP2 may be formed by depositing a second organic material, and the second organic material may include the same material as that of the first organic material or a different material, for example. The forming of the second cathode CE2 may be performed in a manner similar to the forming of the first cathode CE1 in the first group process (refer to FIG. 9E). In an embodiment, the second cathode CE2 may be formed by depositing the first conductive material, for example. The second lower encapsulation inorganic layer LIL2-I may be formed in a manner similar to forming the first lower encapsulation inorganic layer LIL1-I (refer to FIG. 9E) in the first group process.

In the operation of forming the second emission pattern EP2, the 1-2 dummy layers D12-I spaced apart from the second emission pattern EP2 may be formed together. In the operation of forming the second cathode CE2, the 2-2 dummy layer D22-I spaced apart from the second cathode CE2 may be formed together. The 1-2 dummy layer D12-I and the 2-2 dummy layer D22-I may be disposed on the first protective layer PL1.

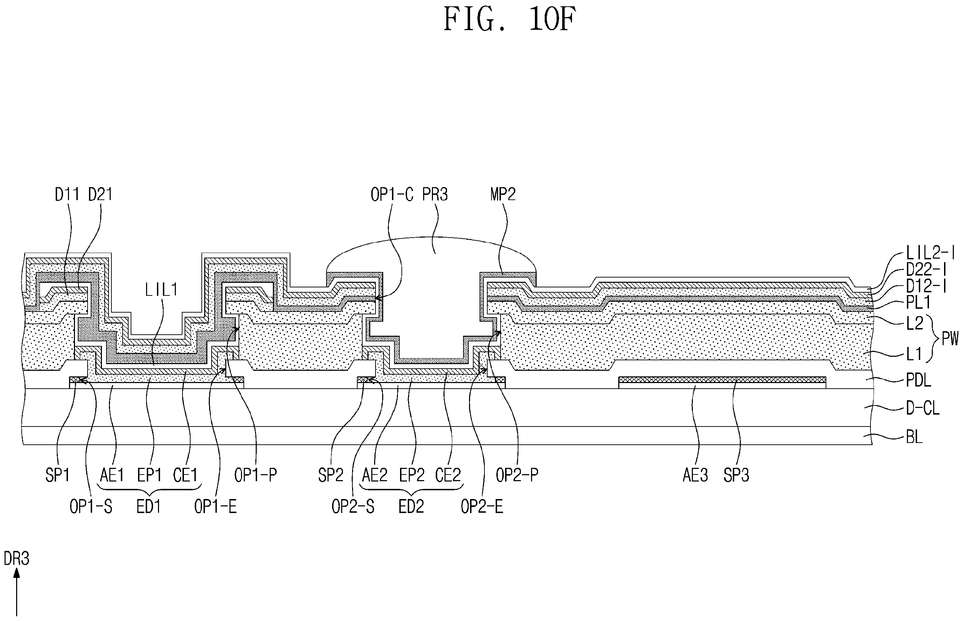

Referring to FIGS. 10E and 10F, the second group process in the illustrated embodiment may include forming a second mask pattern MP2. Forming the second mask pattern MP2 may include forming a second preliminary mask pattern MP2-I on the second lower encapsulation inorganic layer LIL2-I, forming a third photoresist layer PR3 on the second preliminary mask pattern MP2-I, and patterning the second preliminary mask pattern MP2-I.

First, the operation of forming the second preliminary mask pattern MP2-I may be performed in a manner similar to the method of forming the first preliminary mask pattern MP1-I (refer to FIG. 9F) in the first group process. In an embodiment, the second preliminary mask pattern MP2-I may be formed by depositing the second conductive material, for example.

The third photoresist layer PR3 may be formed in a pattern overlapping the second emission opening OP2-E, and may be formed in a manner similar to the manner in which the first photoresist layer PR1 (refer to FIG. 9F) is formed in the first group process.

Thereafter, the second preliminary mask pattern MP2-I may be patterned through a fifth etching process so that the second mask pattern MP2 is formed from the second preliminary mask pattern MP2-I. The patterning of the second preliminary mask pattern MP2-I may be performed in a manner similar to the operation of patterning the first preliminary mask pattern MP1-I (refer to FIG. 9F) in the first group process. A portion of the second preliminary mask pattern MP2-I overlapping the first and third anodes AE1 and AE3 is removed, so that the second mask pattern MP2 may be formed in a pattern overlapping the second emission opening OP2-E. Specifically, the second mask pattern MP2 may be disposed on the second cathode CE2 and a portion of the partition PW adjacent to the second partition opening OP2-P, overlap the second anode AE2, and non-overlap the first and third anodes AE1 and AE3.

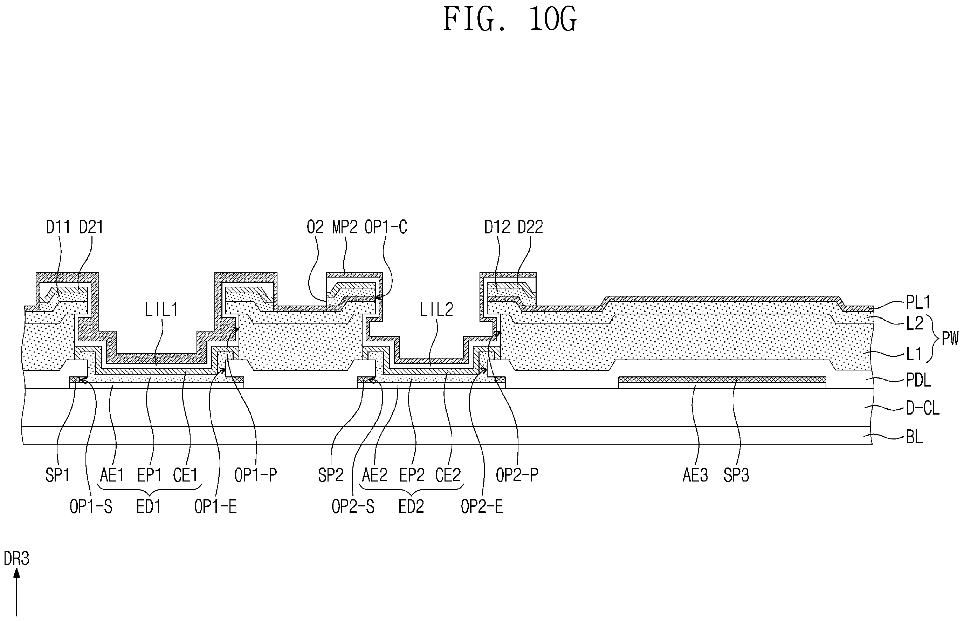

Referring to FIGS. 10F and 10G, the second group process according to this embodiment may include removing the third photoresist layer PR3, patterning a second lower encapsulation inorganic layer LIL2-I through a sixth etching process, and patterning the 1-2 dummy layer D12-I through a seventh etching process. Through the sixth etching process, a second lower encapsulation inorganic pattern LIL2 may be formed from the second lower encapsulation inorganic layer LIL2-I, and through the seventh etching process, the 1-2 dummy pattern D12 may be formed from the 1-2 dummy layer D12-I.

The second lower encapsulation inorganic layer LIL2-I may be formed in a manner similar to forming the first lower encapsulation inorganic layer LIL1-I (refer to FIG. 9E) in the first group process. The patterning of the 1-2 dummy layer D12-I may be performed in a manner similar to patterning the 1-1 dummy layer D11-I (refer to FIG. 9H) in the first group process. In the sixth etching process and the seventh etching process, the second mask pattern MP2 may be used as a mask.

The second lower encapsulation inorganic pattern LIL2 may overlap the second emission opening OP2-E. A part of the second lower encapsulation inorganic pattern LIL2 is disposed in the second partition opening OP2-P to cover the second light-emitting element ED2, and another part of the second lower encapsulation inorganic pattern LIL2 may be disposed on the partition PW and the first protective layer PL1. The 1-2 dummy pattern D12 may have a closed-line shape surrounding the second emission area PXA-G in a plan view. After the seventh etching process, a portion of the first protective layer PL1 that non-overlaps the 1-2 dummy pattern D12 may be exposed.

In the seventh etching process, the 2-2 dummy layer D22-I is also dry etched, so that a 2-2 dummy pattern D22 having a closed-line shape enclosing the second emission area PXA-G in a plan view may be formed together.

In FIGS. 10G and 10H, the second group process in the illustrated embodiment may include forming a second protective layer PL2 from the first protective layer PL1 and the second mask pattern MP2. The second protective layer PL2 may be formed by depositing the same material as that of the material of the first protective layer PL1 and the material of the second mask pattern MP2. Accordingly, the first protective layer PL1 and the second mask pattern MP2 and the newly deposited material may form a second protective layer PL2. The second protective layer PL2 may overlap all of the first to third anodes AE1, AE2, and AE3. In an embodiment, in the operation of forming the second protective layer PL2, a second conductive material may be deposited by a sputtering process, for example.

In the illustrated embodiment, the outer surface O2 of the 1-2 dummy pattern D12 is exposed through the seventh etching process, but by including the operation of forming a second protective layer PL2 after the seventh etching process, the exposed outer surface O2 of the 1-2 dummy pattern D12 may be covered by the second protective layer PL2. Accordingly, damage to the 1-2 dummy patterns D12 may be prevented in the photoresist layer removal operation to be performed later.

In this embodiment, the second protective layer PL2 may include a first portion P1-I and a second portion P2-I. The first portion P1-I may correspond to a portion covering the first lower encapsulation inorganic pattern LIL1, a portion covering the second lower encapsulation inorganic pattern LIL2, and a portion covering the upper surface of the partition PW exposed from the 1-1 and 1-2 dummy patterns D11 and D12. The second portion P2-I may be a portion disposed between the partition PW and the 1-2 dummy pattern D12. The first and second portions P1-I and P2-I may form an integral shape.

After the second group process, a third group process may be performed. In this embodiment, through the third group process, a third light-emitting element ED3 (refer to FIG. 11F) and a third lower encapsulation inorganic pattern LIL3 (refer to FIG. 11F) covering the third light-emitting element may be formed. Hereinafter, the third group process will be described with reference to FIGS. 11A to 11F.

Referring to FIG. 11A, a third group process in the illustrated embodiment may include forming a fourth photoresist layer PR4 on the second protective layer PL2. A second photo opening OP2-R corresponding to the third anode AE3 may be defined in the fourth photoresist layer PR4.

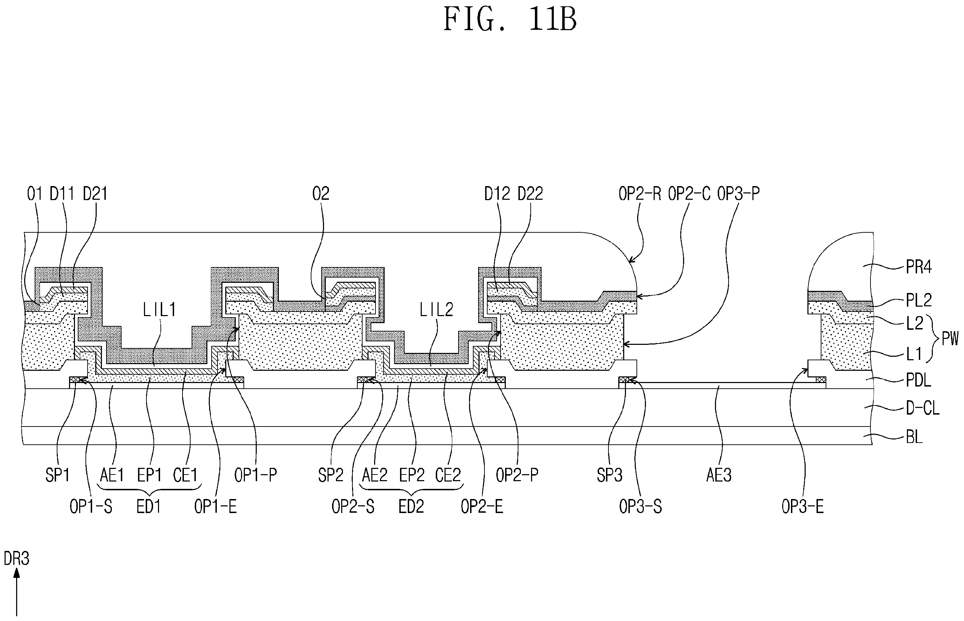

Referring to FIG. 11B, a third group process in the illustrated embodiment may include defining a second sub opening OP2-C in the second protective layer PL2 through a first etching process. The defining of the second sub opening OP2-C may be performed in a similar manner to the defining of the first sub opening OP1-C (refer to FIG. 10B) in the second group process. In the first etching process, the fourth photoresist layer PR4 is used as a mask, and the second sub opening OP2-C may correspond to the second photo opening OP2-R and overlap the third anode AE3.

Then, the third group process according to this embodiment may include defining a third partition opening OP3-P in the partition PW through a second etching process, defining a third emission opening OP3-E in a pixel defining layer PDL through a third etching process, and defining the third sacrificial opening OP3-S in the third sacrificial pattern SP3 through a fourth etching process. At least a portion of the third anode AE3 may be exposed by the third partition opening OP3-P, the third emission opening OP3-E, and the third sacrificial opening OP3-S.

The defining of the third partition openings OP3-P may be performed in a manner similar to the defining of the first partition openings OP1-P in the first group process (refer to FIG. 9C). In this embodiment, the second etching process may include defining the third partition opening OP3-P in the partition PW by the fourth photoresist layer PR4 as a mask, and dry etching and wet etching the first and second layers L1 and L2 sequentially. An inner surface of the partition PW defining the third partition opening OP3-P may have an undercut shape in cross section.

Defining the third emission opening OP3-E and defining the third sacrificial opening OP3-S may be performed in a manner similar to defining the first emission opening OP1-E (refer to FIG. 9D) and defining the first sacrificial opening OP1-S (refer to FIG. 9D) in the first group process, respectively. In the third group process, the third etching process may be performed using the fourth photoresist layer PR4 and the partition PW (e.g. the second layer L2) as a mask, and the fourth etching process may be performed using a pixel defining layer PDL in which a third emission opening OP3-E is defined as a mask.

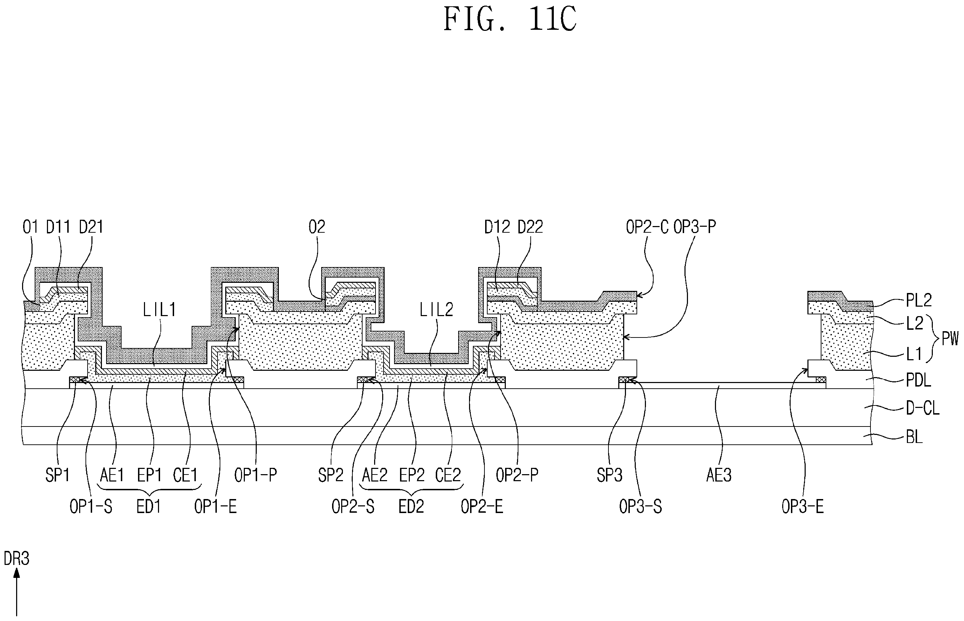

Referring to FIG. 11C, the third group process in the illustrated embodiment may include removing the fourth photoresist layer PR4 (refer to FIG. 11B). In this embodiment, each of the outer surface O1 of the 1-1 dummy pattern D11 and the outer surface O2 of the 1-2 dummy pattern D12 may be provided while being covered by the second protective layer PL2, and the 1-1 and 1-2 dummy patterns D11 and D12 may be prevented from being damaged by the strip solution injected to remove the fourth photoresist layer PR4 (refer to FIG. 11B). Accordingly, lifting of the first and second lower encapsulation inorganic patterns LIL1 and LIL2 may be prevented, so that damage to the first and second light-emitting elements ED1 and ED2 may be prevented.

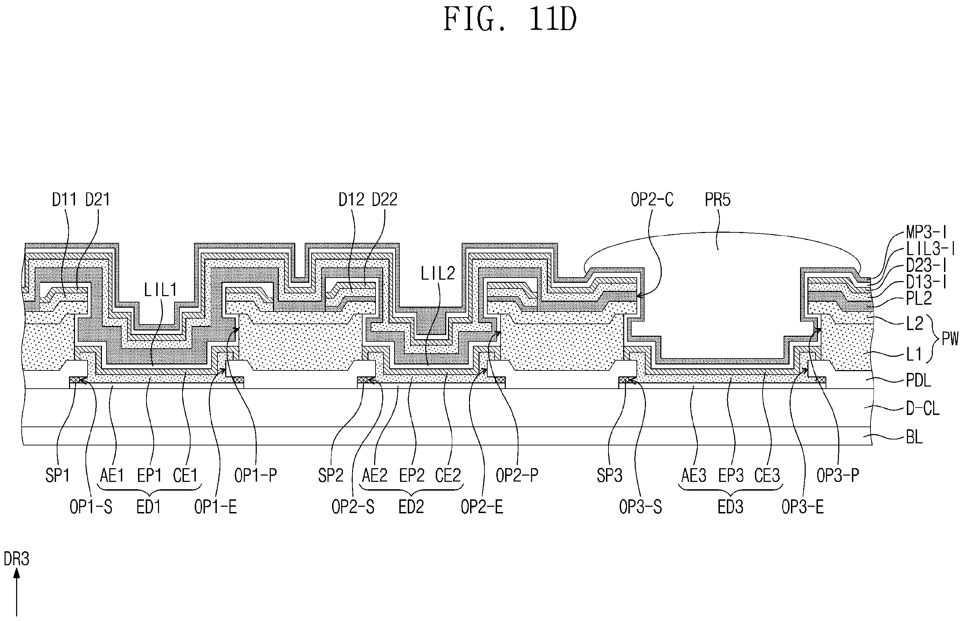

Referring to FIG. 11D, the third group process in the illustrated embodiment may include forming a third emission pattern EP3, forming a third cathode CE3, and forming a third lower encapsulation inorganic layer LIL3-I.

The forming of the third emission pattern EP3 may be performed in a manner similar to the forming of the first emission pattern EP1 in the first group process (refer to FIG. 9E). In an embodiment, the third emission pattern EP3 may be formed by depositing a third organic material, and the third organic material may include a material different from the first organic material and the second organic material, or may include the same material as that of the first organic material or the second organic material, for example. The forming of the third cathode CE3 may be performed in a manner similar to the forming of the first cathode CE1 in the first group process (refer to FIG. 9E). In an embodiment, the third cathode CE3 may be formed by depositing the first conductive material, for example. The third lower encapsulation inorganic layer LIL3-I may be formed in a manner similar to the method of forming the first lower encapsulation inorganic layer LII,1-I (refer to FIG. 9E) in the first group process.

In the operation of forming the third emission pattern EP3, the 1-3 dummy layers D13-I spaced apart from the third emission pattern EP3 may be formed together. In the operation of forming the third cathode CE3, the 2-3 dummy layer D23-I spaced apart from the third cathode CE3 may be formed together. The 1-3 dummy layer D13-I and the 2-3 dummy layer D23-I may be disposed on the second protective layer PL2.

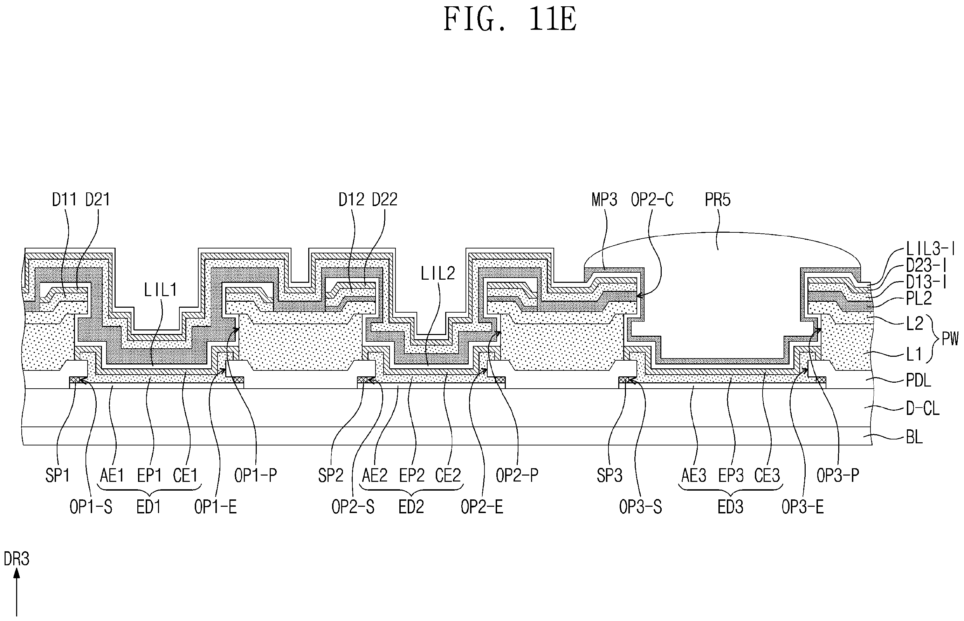

Referring to FIGS. 11D and 11E, the third group process in the illustrated embodiment may include forming a third mask pattern MP3. Forming the third mask pattern MP3 may include forming a third preliminary mask pattern MP3-I on the third lower encapsulation inorganic layer LIL3-I, forming a fifth photoresist layer PR5 on the third preliminary mask pattern MP3-I, and patterning the third preliminary mask pattern MP3-I.

Forming the third preliminary mask pattern MP3-I, forming the fifth photoresist layer PR5, and patterning the third preliminary mask pattern MP3-I may be performed in a manner similar to forming first preliminary mask patterns MP1-I (refer to FIG. 9F), forming a first photoresist layer PR1 (refer to FIG. 9F), and patterning the first preliminary mask pattern MP1-I (refer to FIG. 9F), respectively.

In the third group process, through the fifth etching process, the third preliminary mask pattern MP3-I may be patterned so that the third mask pattern MP3 is formed from the third preliminary mask pattern MP3-I. At this time, a portion overlapping the first and second anodes AE1 and AE2 of the third preliminary mask pattern MP3-I is removed, so that the third mask pattern MP3 may be formed in a pattern overlapping the third emission opening OP3-E. Specifically, the third mask pattern MP3 may be disposed on the third cathode CE3 and a portion of the partition PW adjacent to the third partition opening OP3-P, overlap the third anode AE3, and non-overlap the first and second anodes AE1 and AE2.

Referring to FIGS. 11E and 11F, the third group process in the illustrated embodiment may include removing the fifth photoresist layer PR5, patterning a third lower encapsulation inorganic layer LIL3-I through a sixth etching process, and patterning the 1-3 dummy layers D13-I through a seventh etching process. Through the sixth etching process, a third lower encapsulation inorganic pattern LIL3 may be formed from the third lower encapsulation inorganic layer LIL3-I, and through the seventh etching process, the 1-3 dummy patterns D13 may be formed from the 1-3 dummy layers D13-I.

Patterning the third lower encapsulation inorganic layer LIL3-I and patterning the 1-3 dummy layers D13-I may be performed in a manner similar to a method of patterning the first lower encapsulation inorganic layer LIL1-I (refer to FIG. 9H) and a method of patterning the 1-1 dummy layer D11-I (refer to FIG. 9H), respectively.

In the sixth etching process and the seventh etching process of the third group process, the third mask pattern MP3 may be used as a mask. In the seventh etching process of the third group process, the 2-3 dummy layer D23-I is also dry etched, so that 2-3 dummy patterns D23 having a closed-line shape surrounding the third emission area PXA-B (refer to FIG. 5A) in a plan view may be formed together. After the seventh etching process of the third group process, a portion of the second protective layer PL2 that does not overlap with the 1-3 dummy patterns D13 may be exposed.

Through the first to third group processes, the first to third light-emitting elements ED1, ED2, and ED3 and the first to third lower encapsulation inorganic patterns LII,1, LIL2, and LIL3 may be formed.

Referring to FIGS. 11F and 11G, in this specification, the second protective layer PL2 remaining after the third group process may be also referred to as a first cover layer CL1, and the remaining third mask pattern MP3 may be also referred to as a second cover layer CL2.

The first cover layer CL1 may include a first portion P1, a second portion P2, and a third portion P3. The first portion P1 may be a portion covering a portion exposed from the first and second dummy patterns DMP1 and DMP2 among the upper surfaces of the first and second lower encapsulation inorganic patterns LIL1 and LIL2 and the partition PW. The second portion P2 may be a portion disposed between the partition PW and the 1-2 dummy pattern D12. The third portion P3 may be disposed between the partition PW and the 1-3 dummy pattern D13.

In this embodiment, the thickness t1 of the portion disposed on the first lower encapsulation inorganic pattern LIL1 of the first portion P1 may be greater than the thickness t2 of the portion of the first portion P1 disposed on the second lower encapsulation inorganic pattern LIL2. A thickness t3 of the second portion P2 may be less than a thickness of a portion of the first portion P1 that contacts the upper surface of the partition PW. A thickness t4 of the third portion P3 may be greater than a thickness t3 of the second portion P2.

The second cover layer CL2 may be a portion disposed on the third lower encapsulation inorganic pattern LIL3. In this embodiment, the thickness t5 of the second cover layer CL2 may be less than the thickness t1 of the first portion P1 disposed on the first lower encapsulation inorganic pattern LIL1 and the thickness t2 of the first portion P1 disposed on the second lower encapsulation inorganic pattern LIL2.

After that, a fourth group process may be performed, and the display panel DP including the encapsulation layer TFE may be completed through the fourth group process. The fourth group process according to this embodiment may include forming an encapsulation organic layer OL on the first cover layer CL1 and the second cover layer CL2, and forming an upper encapsulation inorganic layer UIL on the encapsulation organic layer OL. Through this, the display panel DP including the base layer BL, the circuit element layer D-CL, the display element layer D-OL, and the encapsulation layer TFE may be formed.

FIGS. 12A to 12E are cross-sectional views illustrating some of operations in a method of manufacturing a display panel according to the inventive concept. According to the display panel manufacturing method in the illustrated embodiment, no residue of the second conductive material used during the manufacturing process may be left. Hereinafter, it will be described in detail with reference to FIGS. 12A to 12E. The same/similar reference numerals are used for the same/similar configurations as those described in FIGS. 9A to 11G, and redundant descriptions will be omitted, and the differences will be mainly described.

First, with reference to FIG. 12A, differences in the illustrated embodiment compared to the embodiment described in FIG. 9J among the first group processes will be described.

A first group process according to this embodiment may include forming a first protective layer PL1-A on the partition PW. In this embodiment, the first protective layer PL1-A may include a material different from that of the first mask pattern MP1. In an embodiment, the first protective layer PL1-A may include at least one of an inorganic layer and a carbon layer. The first protective layer PL1-A may be formed by chemical vapor deposition, but is not limited thereto.

The material of the first protective layer PL1-A is not limited to the above example. In an embodiment, even when the first protective layer PL1-A may be etched in a different way from the etching method of the first preliminary mask pattern MP1-I (refer to FIG. 9F), the embodiment of FIG. 12A may be applied, for example. In this case, the first protective layer PL1-A may include a third conductive material different from the second conductive material, and for example, may include a transparent conductive oxide of a material different from the material of the transparent conductive oxide included in the first mask pattern MP1.

The first protective layer PL1-A may overlap all of the first to third anodes AE1, AE2, and AE3. The first protective layer PL1-A may be formed to cover the first mask pattern MP1, the outer surface of the first lower encapsulation inorganic pattern LIL1, and the outer surface of the 1-1 dummy pattern D11. In the illustrated embodiment, the outer surface of the 1-1 dummy pattern D11 is exposed through the sixth etching process, but by including the operation of forming the first protective layer PL1-A after the sixth etching process, an exposed outer surface of the 1-1 dummy pattern D11 may be covered by a first protective layer PL1-A. Accordingly, damage to the first light-emitting element ED1 may be prevented by preventing damage to the 1-1 dummy pattern D11 in the subsequent operation of removing the photoresist layer.

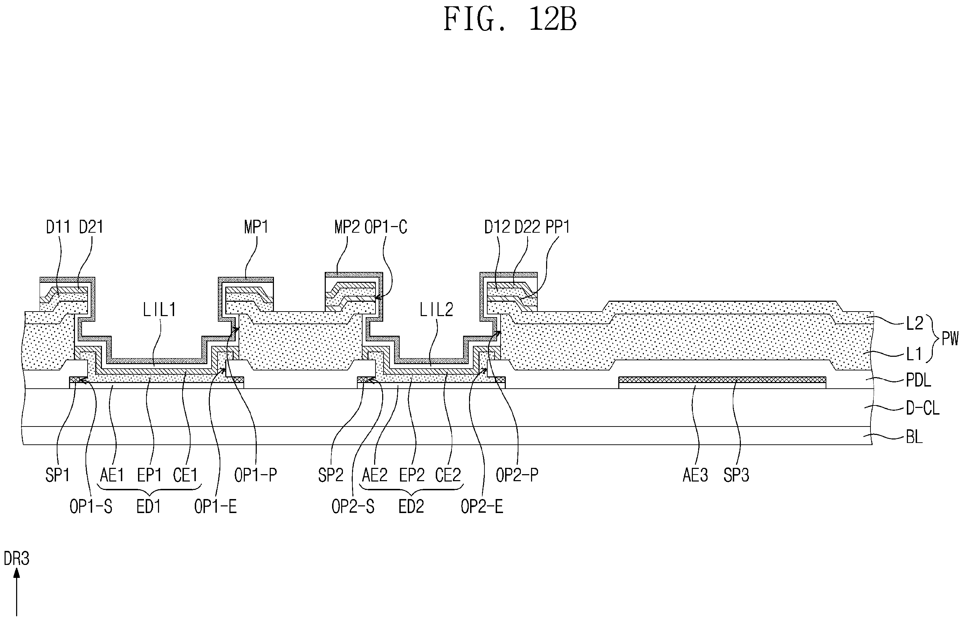

Referring to FIG. 12B, a difference between the second group process and the previous embodiment in FIG. 10G in this embodiment will be described.

In the seventh etching process of the second group process in the illustrated embodiment, during the process of etching the 1-2 dummy layers D12-I (refer to FIG. 10F), the first protective layer PL1-A may be etched together. A portion of the first protective layer PL1-A that does not overlap the second mask pattern MP2 may be removed to form the first protective pattern PP1 from the first protective layer PL1-A. The first protective pattern PP1 may be disposed between the partition PW and the 1-2 dummy pattern D12 and may be formed in a closed line shape in a plan view.

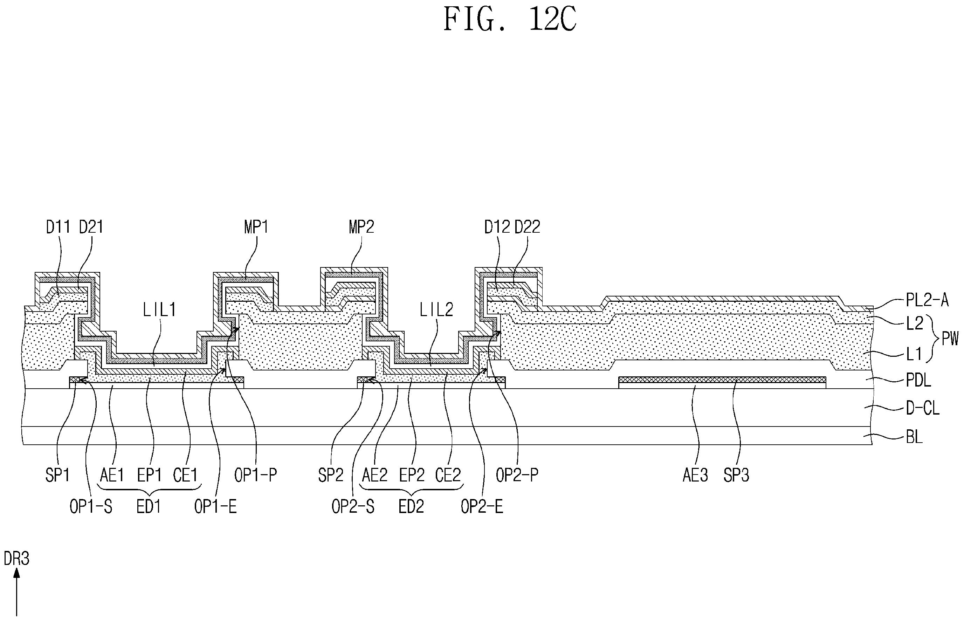

Referring to FIG. 12C, a difference between the second group process and the previous embodiment in FIG. 10H of the illustrated embodiment will be described.

The second group process in the illustrated embodiment may include forming a second protective layer PL2-A from the first protective pattern PP1 (refer to FIG. 12B) after the seventh etching process. In this embodiment, the second protective layer PL2-A may include a material different from that of the first and second mask patterns MP1 and MP2. In an embodiment, the second protective layer PL2-A may include at least one of an inorganic layer and a carbon layer, for example. The second protective layer PL2-A may be formed by chemical vapor deposition, but is not limited thereto.

The material of the second protective layer PL2-A is not limited to the above example. In an embodiment, even when the second protective layer PL2-A may be etched by a method different from that of the first and second preliminary mask patterns MP1-I and MP2-I (refer to FIGS. 9F and 10E), the embodiment of FIG. 12C may be applied, for example. In this case, the second protective layer PL2-A may include a third conductive material different from the second conductive material, and for example, may include a transparent conductive oxide of a material different from the material of the transparent conductive oxide included in the first and second mask patterns MP1 and MP2.

The first protective pattern PP1 and the newly deposited material may form a second protective layer PL2-A. The second protective layer PL2-A may overlap all of the first to third anodes AE1, AE2, and AE3. The second protective layer PL2-A may be formed to cover the first and second mask patterns MP1 and MP2, the outer surfaces of each of the first and second lower encapsulation inorganic patterns LIL1 and LIL2, and the outer surfaces of each of the 1-1 and 1-2 dummy patterns D11 and D12.

According to this embodiment, although the outer surfaces of each of the 1-1 and 1-2 dummy patterns D11 and D12 are exposed through the seventh etching process, by including the operation of forming a second protective layer PL2-A after the seventh etching process, an exposed outer surface of each of the 1-1 and 1-2 dummy patterns D11 and D12 may be covered by a second protective layer PL2-A. Accordingly, in the operation of removing the photoresist layer to be described, damage to the first and second light-emitting elements ED1 and ED2 may be prevented by preventing damage to the 1-1 and 1-2 dummy patterns D11 and D12.

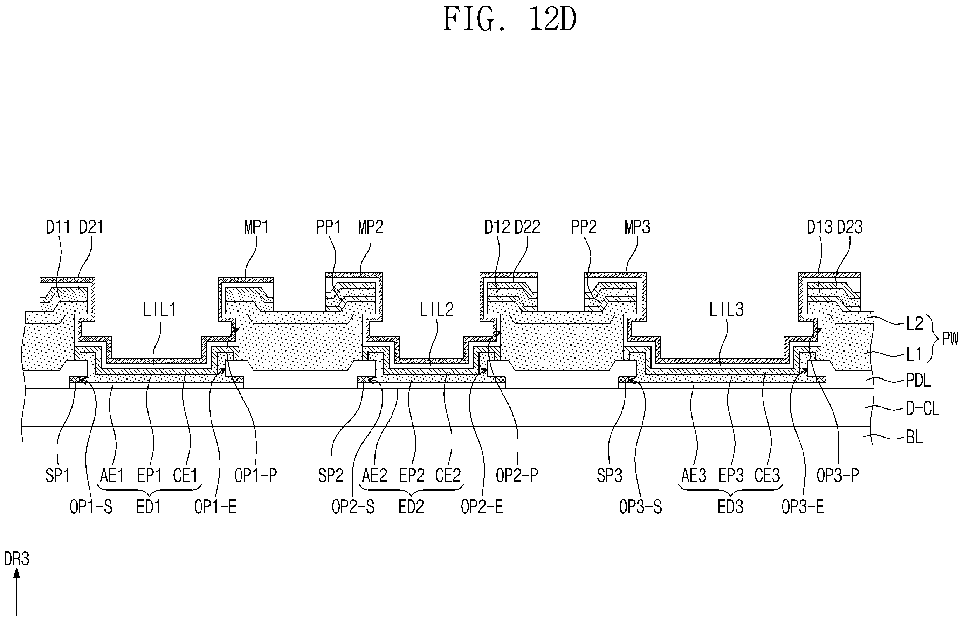

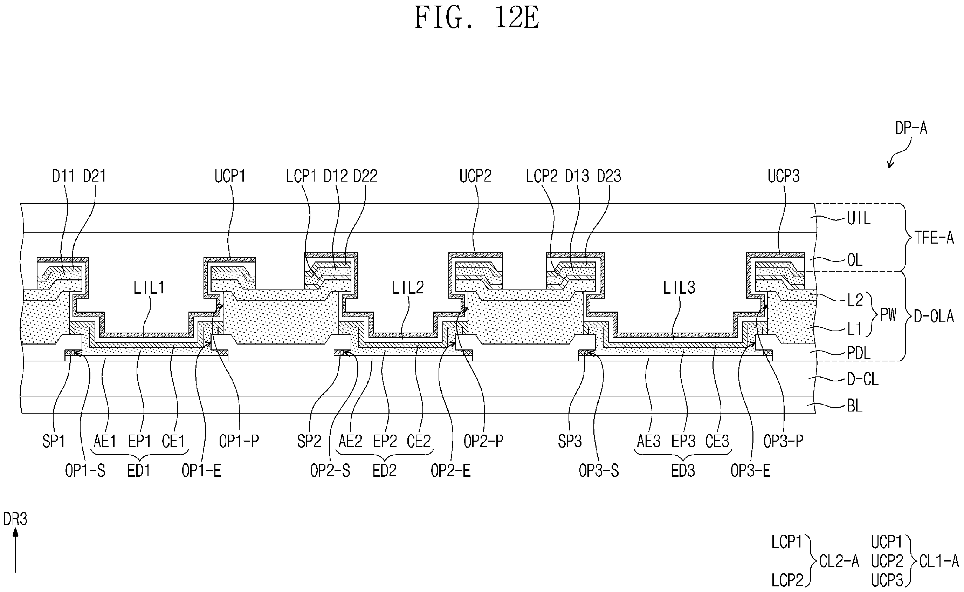

Referring to FIGS. 12D and 12E, differences in this embodiment compared to the above-described embodiment in FIGS. 11F and 11G among third group processes will be described.

First, referring to FIG. 12D, in the third group process in the illustrated embodiment, the second protective layer PL2-A (refer to FIG. 12C) may be etched together in the seventh etching process. A non-overlapping portion of the second protective layer PL2-A (refer to FIG. 12C) with the third mask pattern MP3 is removed, so that a first protective pattern PP1 and a second protective pattern PP2 may be formed from the second protective layer PL2-A (refer to FIG. 12C). The description of the first protective pattern PP1 described above with reference to FIG. 12B may be equally applied to the second protective pattern PP2. The second protective pattern PP2 is disposed between the partition PW and the 1-3 dummy patterns D13, and may be formed in a closed line shape in a plan view.

Referring to FIG. 12E, after the third group process, remaining first to third mask patterns MP1, MP2, and MP3 (refer to FIG. 12D) may correspond to the first cover layer CL1-A. The first cover layer CL1-A may include first to third upper cover patterns UCP1, UCP2, and UCP3 respectively corresponding to the first to third mask patterns MP1, MP2, and MP3 (refer to FIG. 12D). After the third group process, the remaining first and second protective patterns PP1 and PP2 (refer to FIG. 12D) may correspond to the second cover layer CL2-A. The second cover layer CL2-A may include first and second lower cover patterns LCP1 and LCP2 respectively corresponding to the first and second protective patterns PP1 and PP2 (refer to FIG. 12D).

Thereafter, a fourth group process may be performed, and the display panel DP-A including the encapsulation layer TFE-A may be completed through the fourth group process. The fourth group process according to this embodiment may include forming an encapsulation organic layer OL on the partition PW and the second cover layer CL2-A, and forming an upper encapsulation inorganic layer UIL on the encapsulation organic layer OL. Through this, the display panel DP-A including the base layer BL, the circuit element layer D-CL, the display element layer D-OLA, and the encapsulation layer TFE-A may be formed.

According to the inventive concept, since a light-emitting layer may be patterned without a metal mask, a display panel with improved process reliability and easy implementation of relatively high resolution may be provided.

According to the inventive concept, it is possible to prevent the lifting of the encapsulation inorganic pattern by preventing damage to the organic pattern disposed under the encapsulation inorganic pattern. Through this, it is possible to prevent the inflow of foreign substances such as moisture, and light-emitting elements with improved process reliability and reduced defects and a display panel including the light-emitting elements may be provided.

According to the inventive concept, a method for manufacturing a display panel capable of providing light-emitting elements having relatively high resolution and improved process reliability may be provided.

Although the embodiments of the inventive concept have been described, it is understood that the inventive concept should not be limited to these embodiments but various changes and modifications may be made by one ordinary skilled in the art within the scope of the inventive concept as hereinafter claimed.

The present invention can be defined by reference to the following clauses:
Clause 1. A display panel comprising:
   a base layer;
   a pixel defining layer defining a first emission opening and disposed on the base layer;
   a partition defining a first partition opening corresponding to the first emission opening and disposed on the pixel defining layer;
   a first light-emitting element including a first anode at least partially exposed by the first emission opening, a first cathode including at least a portion disposed within the first partition opening and contacting the partition, and a first emission pattern disposed between the first anode and the first cathode;
   a first lower encapsulation inorganic pattern partially overlapping the first emission opening and disposed on the first light-emitting element and the partition; and
   a first cover layer partially overlapping the first emission opening and disposed on the first lower encapsulation inorganic pattern.
Clause 2. The display panel of clause 1, wherein the first cover layer comprises a transparent conductive oxide.
Clause 3. The display panel of clause 1 or clause 2, wherein a refractive index of the first cover layer is about 1.5 or more and about 2.0 or less.
Clause 4. The display panel of any one of clauses 1 to 3, wherein a difference between a refractive index of the first cover layer and a refractive index of the first lower encapsulation inorganic pattern is about 0.4 or less.
Clause 5. The display panel of any one of clauses 1 to 4, wherein the first cover layer entirely overlaps the first lower encapsulation inorganic pattern in a plan view.
Clause 6. The display panel of any one of clauses 1 to 5, wherein the first cover layer contacts an outer surface of the first lower encapsulation inorganic pattern and an upper surface of the partition.
Clause 7. The display panel of any one of clauses 1 to 5, wherein the first cover layer comprises a first upper cover pattern spaced apart from the partition, and
   wherein an outer surface of the first upper cover pattern is substantially aligned with an outer surface of the first lower encapsulation inorganic pattern.
Clause 8. The display panel of clause 1, further comprising:
   a second light-emitting element including a second anode, a second emission pattern, and a second cathode; and
   a second lower encapsulation inorganic pattern,
   wherein a second emission opening exposing at least a portion of the second anode is defined in the pixel defining layer,
   wherein a second partition opening corresponding to the second emission opening and having the second emission pattern and the second cathode disposed therein is defined in the partition, and
   wherein the second lower encapsulation inorganic pattern partially overlaps the second emission opening and is disposed on the second light-emitting element and the partition.
Clause 9. The display panel of clause 8, wherein the first cover layer comprises:
   a first portion covering the first and second lower encapsulation inorganic patterns and a non-overlapping area with the first and second lower encapsulation inorganic patterns of an upper surface of the partition; and
   a second portion connected to the first portion, disposed between the partition and the second lower encapsulation inorganic pattern, and defining a first sub opening corresponding to the second emission opening.
Clause 10. The display panel of clause 9, wherein the second portion has a closed-line shape in a plan view.
Clause 11. The display panel of clause 9 or clause 10, wherein a thickness of a portion of the first portion disposed on the first lower encapsulation inorganic pattern is greater than a thickness of a portion of the first portion disposed on the second lower encapsulation inorganic pattern.
Clause 12. The display panel of any one of clauses 9 to 11, further comprising:
   a 1-1 dummy pattern contacting the partition, disposed on the partition, defining a first dummy opening corresponding to the first emission opening, and including a same material as a material of the first emission pattern; and
   a 1-2 dummy pattern disposed on the second portion, defining a second dummy opening corresponding to the second emission opening, and including a same material as a material of the second emission pattern.
Clause 13. The display panel of any one of clauses 9 to 12, further comprising;
   a third light-emitting element including a third anode, a third emission pattern, and a third cathode;
   a third lower encapsulation inorganic pattern; and
   a second cover layer disposed on the third lower encapsulation inorganic pattern,
   wherein a third emission opening exposing at least a portion of the third anode is defined in the pixel defining layer,
   wherein a third partition opening corresponding to the third emission opening and having the third emission pattern and the third cathode disposed therein is defined in the partition,
   wherein the third lower encapsulation inorganic pattern partially overlaps the third emission opening and is disposed on the third light-emitting element and the partition, and
   wherein the first cover layer further comprises a third portion disposed between the partition and the third lower encapsulation inorganic pattern.
Clause 14. The display panel of clause 13, wherein the second cover layer comprises a transparent conductive oxide.
Clause 15. The display panel of clause 13 or clause 14, wherein a thickness of the third portion is greater than a thickness of the second portion.
Clause 16. The display panel of any one of clauses 13 to 15, wherein a thickness of the second cover layer is less than a thickness of a portion of the first portion disposed on the first lower encapsulation inorganic pattern and a thickness of a portion of the first portion disposed on the second lower encapsulation inorganic pattern.
Clause 17. The display panel of clause 8, further comprising
   a second cover layer including a first lower cover pattern disposed between the partition and the second lower encapsulation inorganic pattern and defining a first sub opening corresponding to the second emission opening,
   wherein the first cover layer comprises:
      a first upper cover pattern partially overlapping the first emission opening and disposed on the first lower encapsulation inorganic pattern; and
      a second upper cover pattern partially overlapping the second emission opening and disposed on the second lower encapsulation inorganic pattern, and
   wherein the second upper cover pattern overlaps the first lower cover pattern in a plan view.
Clause 18. The display panel of clause 17, wherein the first lower cover pattern has a closed-line shape in the plan view.
Clause 19. The display panel of clause 17 or clause 18, wherein the second cover layer comprises at least one of an inorganic film and a carbon film.
Clause 20. The display panel of any one of clauses 17 to 19, wherein a refractive index of the second cover layer is about 1.5 or more and about 2.0 or less.
Clause 21. The display panel of any one of clauses 17 to 20, further comprising:
   a 1-1 dummy pattern contacting the partition, disposed on the partition, defining a first dummy opening corresponding to the first emission opening, and including a same material as a material of the first emission pattern; and
   a 1-2 dummy pattern disposed on the first lower cover pattern, defining a second dummy opening corresponding to the second emission opening, and including a same material as a material of the second emission pattern.
Clause 22. The display panel of any one of clauses 17 to 21, further comprising:
   a third light-emitting element including a third anode, a third emission pattern, and a third cathode; and
   a third lower encapsulation inorganic pattern,
   wherein a third emission opening exposing at least a portion of the third anode is defined in the pixel defining layer,
   wherein a third partition opening corresponding to the third emission opening and having the third emission pattern and the third cathode disposed therein is defined in the partition,
   wherein the third lower encapsulation inorganic pattern partially overlaps the third emission opening and is disposed on the third light-emitting element and the partition,
   wherein the second cover layer further comprises a second lower cover pattern disposed between the partition and the third lower encapsulation inorganic pattern and defining a second sub opening corresponding to the third emission opening, and
   wherein the first cover layer further comprises a third upper cover pattern partially overlapping the third emission opening, disposed on the third lower encapsulation inorganic pattern, and overlapping the second lower cover pattern in the plan view.
Clause 23. The display panel of any one of clauses 1 to 22, wherein the partition comprises:
   a first layer including a first inner surface defining a first area of the first partition opening and having a first conductivity; and
   a second layer including a second inner surface defining a second area of the first partition opening, having a second conductivity and disposed on the first layer,
   wherein the first conductivity is higher than the second conductivity, and
   wherein the first inner surface is recessed inward than the second inner surface.
Clause 24. A display panel manufacturing method comprising:
   providing a preliminary display panel including a base layer, a first anode disposed on the base layer, a pixel defining layer disposed on the base layer and defining a first emission opening exposing a portion of the first anode, and a partition disposed on the pixel defining layer and defining a first partition opening corresponding to the first emission opening;
   forming a first emission pattern within the first emission opening and the first partition opening;
   forming a first cathode on the first emission pattern;
   forming a first mask pattern on a portion of the first cathode and the partition adjacent to the first partition opening;
   etching using the first mask pattern; and
   forming a first protective layer on the first cathode and the partition,
   wherein, in the forming the first emission pattern, a 1-1 dummy layer including a same material as a material of the first emission pattern and disposed on the partition is formed,
   wherein, in the etching using the first mask pattern, a 1-1 dummy pattern is formed from the 1-1 dummy layer, and
   wherein the first protective layer covers an outer surface of the 1-1 dummy pattern.
Clause 25. The method of clause 24, wherein, in the forming the first protective layer, a conductive material is deposited, and the first protective layer is formed from the first mask pattern and the deposited conductive material.
Clause 26. The method of clause 24, wherein, in the forming the first protective layer, at least one of an inorganic material and carbon is deposited, and the first protective layer covers the first mask pattern.
Clause 27. The method of clause 24 further comprising, after the forming the first protective layer:
   defining a first sub opening in the first protective layer;
   defining a second partition opening in the partition;
   defining a second emission opening in the pixel defining layer;
   forming a second emission pattern within the second emission opening and the second partition opening;
   forming a second cathode on the second emission pattern;
   forming a second mask pattern on the second cathode and a portion of the partition adjacent to the second partition opening;
   etching using the second mask pattern; and
   forming a second protective layer on the first and second cathodes and the partition,
   wherein, in the providing the preliminary display panel, the preliminary display panel further comprises a second anode spaced apart from the first anode, and
   wherein the first sub opening overlaps the second anode.
Clause 28. The method of clause 27, wherein in the forming the second emission pattern, a 1-2 dummy layer including a same material as a material of the second emission pattern and disposed on the partition is formed,
   wherein in the etching using the second mask pattern, a 1-2 dummy pattern is formed from the 1-2 dummy layer,
   wherein in the forming the second protective layer, a conductive material is deposited, and the second protective layer is formed from the second mask pattern and the deposited conductive material, and
   wherein the second protective layer covers an outer surface of the 1-2 dummy pattern.
Clause 29. The method of clause 27, wherein in the etching using the second mask pattern, a portion of the first protective layer which does not overlap with the second mask pattern is removed to form a first protective pattern.
Clause 30. The method of clause 29, wherein in the forming the second protective layer, at least one of an inorganic material and carbon is deposited, the second protective layer is formed from the first protective pattern and the deposited at least one of inorganic material and carbon, and the second protective layer covers the first and second mask patterns.

## Claims

1. A display panel comprising:
a base layer;
a pixel defining layer defining a first emission opening and disposed on the base layer;
a partition defining a first partition opening corresponding to the first emission opening and disposed on the pixel defining layer;
a first light-emitting element including a first anode at least partially exposed by the first emission opening, a first cathode including at least a portion disposed within the first partition opening and contacting the partition, and a first emission pattern disposed between the first anode and the first cathode;
a first lower encapsulation inorganic pattern partially overlapping the first emission opening and disposed on the first light-emitting element and the partition; and
a first cover layer partially overlapping the first emission opening and disposed on the first lower encapsulation inorganic pattern.

2. The display panel of claim 1, wherein the first cover layer comprises a transparent conductive oxide.

3. The display panel of claim 1 or claim 2, wherein:
(i) a refractive index of the first cover layer is about 1.5 or more and about 2.0 or less; and/or
(ii) a difference between a refractive index of the first cover layer and a refractive index of the first lower encapsulation inorganic pattern is about 0.4 or less; and/or
(iii) the first cover layer entirely overlaps the first lower encapsulation inorganic pattern in a plan view.

4. The display panel of any one of claims 1 to 3, wherein:
(i) the first cover layer contacts an outer surface of the first lower encapsulation inorganic pattern and an upper surface of the partition; or
(ii) the first cover layer comprises a first upper cover pattern spaced apart from the partition, and
wherein an outer surface of the first upper cover pattern is substantially aligned with an outer surface of the first lower encapsulation inorganic pattern.

5. The display panel of claim 1, further comprising:
a second light-emitting element including a second anode, a second emission pattern, and a second cathode; and
a second lower encapsulation inorganic pattern,
wherein a second emission opening exposing at least a portion of the second anode is defined in the pixel defining layer,
wherein a second partition opening corresponding to the second emission opening and having the second emission pattern and the second cathode disposed therein is defined in the partition, and
wherein the second lower encapsulation inorganic pattern partially overlaps the second emission opening and is disposed on the second light-emitting element and the partition.

6. The display panel of claim 5, wherein the first cover layer comprises:
a first portion covering the first and second lower encapsulation inorganic patterns and a non-overlapping area with the first and second lower encapsulation inorganic patterns of an upper surface of the partition; and
a second portion connected to the first portion, disposed between the partition and the second lower encapsulation inorganic pattern, and defining a first sub opening corresponding to the second emission opening.

7. The display panel of claim 6, wherein:
(i) the second portion has a closed-line shape in a plan view; and/or
(ii) a thickness of a portion of the first portion disposed on the first lower encapsulation inorganic pattern is greater than a thickness of a portion of the first portion disposed on the second lower encapsulation inorganic pattern; and/or
(iii) the display panel further comprises:
a 1-1 dummy pattern contacting the partition, disposed on the partition, defining a first dummy opening corresponding to the first emission opening, and including a same material as a material of the first emission pattern; and
a 1-2 dummy pattern disposed on the second portion, defining a second dummy opening corresponding to the second emission opening, and including a same material as a material of the second emission pattern.

8. The display panel of claim 6 or claim 7, further comprising;
a third light-emitting element including a third anode, a third emission pattern, and a third cathode;
a third lower encapsulation inorganic pattern; and
a second cover layer disposed on the third lower encapsulation inorganic pattern,
wherein a third emission opening exposing at least a portion of the third anode is defined in the pixel defining layer,
wherein a third partition opening corresponding to the third emission opening and having the third emission pattern and the third cathode disposed therein is defined in the partition,
wherein the third lower encapsulation inorganic pattern partially overlaps the third emission opening and is disposed on the third light-emitting element and the partition, and
wherein the first cover layer further comprises a third portion disposed between the partition and the third lower encapsulation inorganic pattern.

9. The display panel of claim 8, wherein:
(i) the second cover layer comprises a transparent conductive oxide; and/or
(ii) a thickness of the third portion is greater than a thickness of the second portion; and/or
(iii) a thickness of the second cover layer is less than a thickness of a portion of the first portion disposed on the first lower encapsulation inorganic pattern and a thickness of a portion of the first portion disposed on the second lower encapsulation inorganic pattern.

10. The display panel of claim 5, further comprising
a second cover layer including a first lower cover pattern disposed between the partition and the second lower encapsulation inorganic pattern and defining a first sub opening corresponding to the second emission opening,
wherein the first cover layer comprises:
a first upper cover pattern partially overlapping the first emission opening and disposed on the first lower encapsulation inorganic pattern; and
a second upper cover pattern partially overlapping the second emission opening and disposed on the second lower encapsulation inorganic pattern, and
wherein the second upper cover pattern overlaps the first lower cover pattern in a plan view.

11. The display panel of claim 10, wherein:
(i) the first lower cover pattern has a closed-line shape in the plan view; and/or
(ii) the second cover layer comprises at least one of an inorganic film and a carbon film; and/or
(iii) a refractive index of the second cover layer is about 1.5 or more and about 2.0 or less.

12. The display panel of claim 10 or claim 11, further comprising:
(i) a 1-1 dummy pattern contacting the partition, disposed on the partition, defining a first dummy opening corresponding to the first emission opening, and including a same material as a material of the first emission pattern; and
a 1-2 dummy pattern disposed on the first lower cover pattern, defining a second dummy opening corresponding to the second emission opening, and including a same material as a material of the second emission pattern; and/or
(ii) a third light-emitting element including a third anode, a third emission pattern, and a third cathode; and
a third lower encapsulation inorganic pattern,
wherein a third emission opening exposing at least a portion of the third anode is defined in the pixel defining layer,
wherein a third partition opening corresponding to the third emission opening and having the third emission pattern and the third cathode disposed therein is defined in the partition,
wherein the third lower encapsulation inorganic pattern partially overlaps the third emission opening and is disposed on the third light-emitting element and the partition,
wherein the second cover layer further comprises a second lower cover pattern disposed between the partition and the third lower encapsulation inorganic pattern and defining a second sub opening corresponding to the third emission opening, and
wherein the first cover layer further comprises a third upper cover pattern partially overlapping the third emission opening, disposed on the third lower encapsulation inorganic pattern, and overlapping the second lower cover pattern in the plan view.

13. The display panel of any one of claims 1 to 12, wherein the partition comprises:
a first layer including a first inner surface defining a first area of the first partition opening and having a first conductivity; and
a second layer including a second inner surface defining a second area of the first partition opening, having a second conductivity and disposed on the first layer,
wherein the first conductivity is higher than the second conductivity, and
wherein the first inner surface is recessed inward than the second inner surface.

14. A display panel manufacturing method comprising:
providing a preliminary display panel including a base layer, a first anode disposed on the base layer, a pixel defining layer disposed on the base layer and defining a first emission opening exposing a portion of the first anode, and a partition disposed on the pixel defining layer and defining a first partition opening corresponding to the first emission opening;
forming a first emission pattern within the first emission opening and the first partition opening;
forming a first cathode on the first emission pattern;
forming a first mask pattern on a portion of the first cathode and the partition adjacent to the first partition opening;
etching using the first mask pattern; and
forming a first protective layer on the first cathode and the partition, wherein, in the forming the first emission pattern, a 1-1 dummy layer including a same material as a material of the first emission pattern and disposed on the partition is formed,
wherein, in the etching using the first mask pattern, a 1-1 dummy pattern is formed from the 1-1 dummy layer, and
wherein the first protective layer covers an outer surface of the 1-1 dummy pattern.

15. The method of claim 14, wherein:
(i) in the forming the first protective layer, a conductive material is deposited, and the first protective layer is formed from the first mask pattern and the deposited conductive material; or
(ii) in the forming the first protective layer, at least one of an inorganic material and carbon is deposited, and the first protective layer covers the first mask pattern.

16. The method of claim 14 further comprising, after the forming the first protective layer:
defining a first sub opening in the first protective layer;
defining a second partition opening in the partition;
defining a second emission opening in the pixel defining layer;
forming a second emission pattern within the second emission opening and the second partition opening;
forming a second cathode on the second emission pattern;
forming a second mask pattern on the second cathode and a portion of the partition adjacent to the second partition opening;
etching using the second mask pattern; and
forming a second protective layer on the first and second cathodes and the partition,
wherein, in the providing the preliminary display panel, the preliminary display panel further comprises a second anode spaced apart from the first anode, and
wherein the first sub opening overlaps the second anode.

17. The method of claim 16, wherein in the forming the second emission pattern, a 1-2 dummy layer including a same material as a material of the second emission pattern and disposed on the partition is formed,
wherein in the etching using the second mask pattern, a 1-2 dummy pattern is formed from the 1-2 dummy layer,
wherein in the forming the second protective layer, a conductive material is deposited, and the second protective layer is formed from the second mask pattern and the deposited conductive material, and
wherein the second protective layer covers an outer surface of the 1-2 dummy pattern.

18. The method of claim 16, wherein in the etching using the second mask pattern, a portion of the first protective layer which does not overlap with the second mask pattern is removed to form a first protective pattern, optionally wherein in the forming the second protective layer, at least one of an inorganic material and carbon is deposited, the second protective layer is formed from the first protective pattern and the deposited at least one of inorganic material and carbon, and the second protective layer covers the first and second mask patterns.
